# FASCICULE DE BREVET EUROPEEN

(11) **EP 4 449 302 B1**
(45) Date de publication et mention de la délivrance du brevet: **13.08.2025**
(21) Numéro de dépôt: 22846914.4
(22) Date de dépôt: 12.12.2022
(51) Int. Cl.: G06K 19/07, G06K 19/077

(54) **PROCEDE DE FABRICATION D'UN MODULE SANS CONTACT AYANT UNE BOBINE D'ANTENNE A INDUCTANCE FINEMENT AJUSTABLE**
VERFAHREN ZUR HERSTELLUNG EINES KONTAKTLOSEN MODULS MIT EINER ANTENNENSPULE MIT FEIN EINSTELLBARER INDUKTIVITÄT
METHOD FOR MANUFACTURING CONTACTLESS MODULE HAVING AN ANTENNA COIL WITH FINELY ADJUSTABLE INDUCTANCE

(30) Priorité: 24.12.2021 FR 2114517
(43) Date de publication de la demande: 23.10.2024
(73) Titulaire: Sealsq France, 13590 Meyreuil (FR)
(72) Inventeur: BOIRON, Ghislain, 13090 Aix en Provence (FR); ENGUENT, Jean-Pierre, 13090 Aix en Provence (FR)
(74) Mandataire: Marchand, André
(86) Numéro de dépôt international: PCT/FR2022/052314
(87) Numéro de publication internationale: WO 2023/118684

(56) Documents cités:
- EP-A1- 3 016 032
- WO-A1-2014/006286
- WO-A1-2017/191373
- WO-A1-2019/102079
- WO-A1-2020/094320
- FR-A1- 3 105 857

## Description

### DOMAINE TECHNIQUE

La présente invention concerne un module sans contact et procédé de fabrication d'un module sans contact du type comprenant une plaquette recouverte sur une première face d'une première couche électriquement conductrice dans laquelle est formée une bobine d'antenne, la bobine d'antenne comportant des spires de rangs croissants en allant de l'extérieur vers l'intérieur de la bobine d'antenne, dont une spire extérieure de rang 1 et une spire intérieure de rang N, la spire intérieure étant reliée à une plage de connexion intérieure et la spire extérieure reliée à une plage de connexion extérieure, et un microcircuit fixé sur la première face de la plaquette, dans une zone centrale de la bobine d'antenne délimitée par une spire de la bobine d'antenne, et comportant des premières bornes de connexion reliées à des plages de connexion de la bobine d'antenne par l'intermédiaire de fils.

### ETAT DE LA TECHNIQUE

Un module sans contact tel que défini ci-dessus et un procédé de fabrication d'un tel module sans contact sont décrits par WO 2014/006286 A1. Un exemple d'un tel module sans contact M1 est représenté sur la figure 1. Le module sans contact M1 comprend une plaquette B1 recouverte sur une première face, ou face arrière, d'une couche électriquement conductrice dans laquelle a été formée une bobine d'antenne A1. La bobine d'antenne A1 comporte N spires de rang croissant en allant de l'extérieur vers l'intérieur de la bobine d'antenne, ici 8 spires L1 à L8, dont une spire extérieure L1 de rang 1 et une spire intérieure de rang N, ici L8. La spire intérieure L8 est reliée à une plage de connexion intérieure IP et la spire extérieure L1 est reliée à une plage de connexion extérieure EP. Un microcircuit MC est fixé sur la face arrière de la plaquette B1 dans une zone centrale de la bobine d'antenne A1 délimitée par le contour de la spire intérieure L8, et comporte des premières bornes de connexion, ou bornes de connexion d'antenne, reliées aux plages de connexion EP, IP de la bobine d'antenne par l'intermédiaire de fils W1, W2. La spire extérieure L1 suit la totalité du contour de la bobine d'antenne A1 à l'exception d'une zone permettant le passage d'une piste conductrice T1 reliant la spire extérieure à la plage de connexion extérieure EP. Les plages de connexion EP, IP sont formées dans la zone centrale de la bobine d'antenne, la bobine d'antenne comprenant une zone de contournement BA1 dans laquelle chaque spire L1 à L8 contourne la plage de connexion extérieure EP par la zone centrale.

Dans le cadre de la réalisation d'un module sans contact M1 à deux modes de communication, contact et sans contact, dit « dual interface », la plaquette B1 comprend également, sur son autre face, ou face avant, une seconde couche électriquement conductrice dans laquelle sont formées des plages de contact, par exemple 6 plages de contact de type ISO 7816 (non représentées). La plaquette B1 est alors pourvue de trous h permettant le passage de fils CW reliant des secondes bornes de connexion du microcircuit MC, ou bornes de connexion du mode contact, à tout ou partie de ces plages de contact.

Le câblage au moyen des fils W1, W2, CW est généralement réalisé par soudure ultrasonique des extrémités des fils sur les surfaces à interconnecter. Cette technique de câblage appelée généralement « ultrasonic wire bonding » nécessite, de préférence, un montage du microcircuit « à plat » soit parallèle à la surface de la plaquette B1, afin que le plan dans lequel s'étendent les bornes de connexion du microcircuit soit parallèle au plan dans lequel s'étendent les plages de connexion EP, IP de l'antenne et au plan dans lequel s'étendent les plages de contact sur l'autre face du module.

A cet effet une structure support SS1 est prévue au centre de la bobine, pour supporter le microcircuit sur sa largeur et une partie de sa longueur, le microcircuit étant également supporté sur sa largeur et sur une autre partie de sa longueur par des spires de la bobine d'antenne dans la zone de contournement BA1. La structure support SS1 comprend ici un chemin conducteur faisant partie de la spire intérieure L8. Des tronçons conducteurs transversaux forment de chaque côté de celle-ci deux structures en forme de peigne permettant de supporter le microcircuit sur toute sa largeur.

Après montage et câblage du microcircuit MC sur le module, le microcircuit est noyé dans une couche de résine RL électriquement isolante, qui s'étend sur la zone centrale de la bobine d'antenne et recouvre les fils de connexion W1, W2 et CW, pour une parfaite tenue mécanique de ceux-ci.

Une telle structure d'antenne offre divers avantages et notamment celui de raccourcir la longueur du fil W1 reliant le microcircuit à la borne de connexion extérieure EP de la bobine d'antenne, afin que ce fil de connexion soit recouvert par la couche de résine RL sans nécessiter que celle-ci recouvre l'intégralité du module. En effet, comme expliqué dans WO 2014/006286 A1, le module M1 est généralement destiné à être monté dans une cavité formée dans une carte, qui comprend deux profondeurs. La première profondeur permet à la cavité de recevoir la périphérie du module M1. La seconde profondeur est égale à la première profondeur à laquelle s'ajoute l'épaisseur de la couche de résine RL, et permet à la cavité de recevoir la partie du module M1 recouverte de la couche de résine RL. Pour ne pas fragiliser la carte, il est souhaitable que la surface du module recouverte par la couche de résine RL soit minimale, pour que la région de la cavité présentant la seconde profondeur soit également minimale. Cette surface minimale correspond sensiblement à la région centrale de la bobine dans laquelle s'étendent le microcircuit MC et les fils W1, W2, CW.

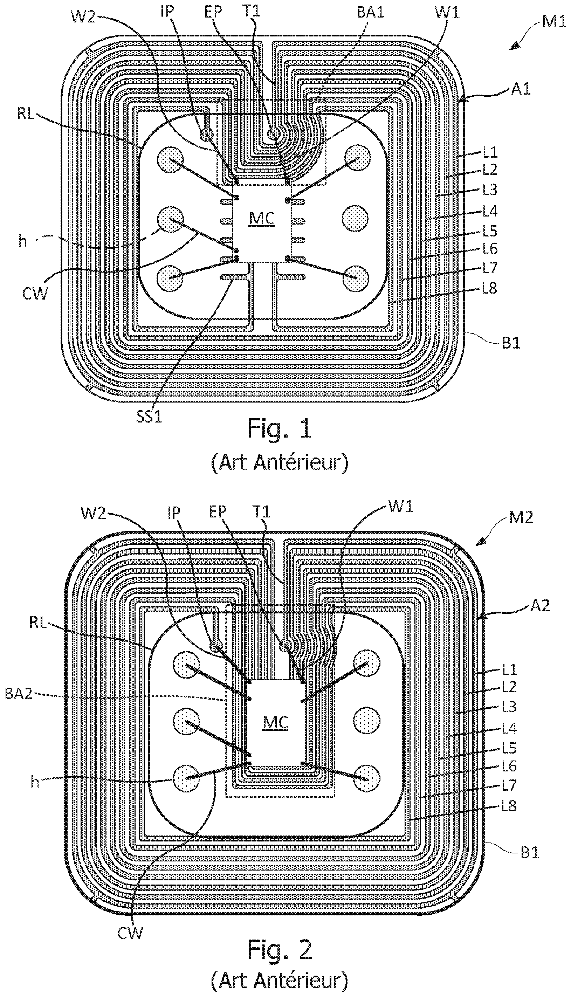

Un autre exemple M2 de module sans contact classique est représenté sur la figure 2. Le module sans contact M2 comprend une bobine d'antenne A2 et présente les mêmes caractéristiques générales que le module M1. Il se distingue du module M1 par le fait qu'il ne comporte aucune structure support, la zone de contournement, ici désignée par la référence BA2, occupant le centre de la bobine d'antenne A2. Ainsi, le microcircuit MC repose sur toute sa longueur et toute sa largeur sur des portions de spires situées dans la zone de contournement. Comme précédemment, cette structure de bobine d'antenne permet de monter le microcircuit MC « à plat » sur la plaquette B1.

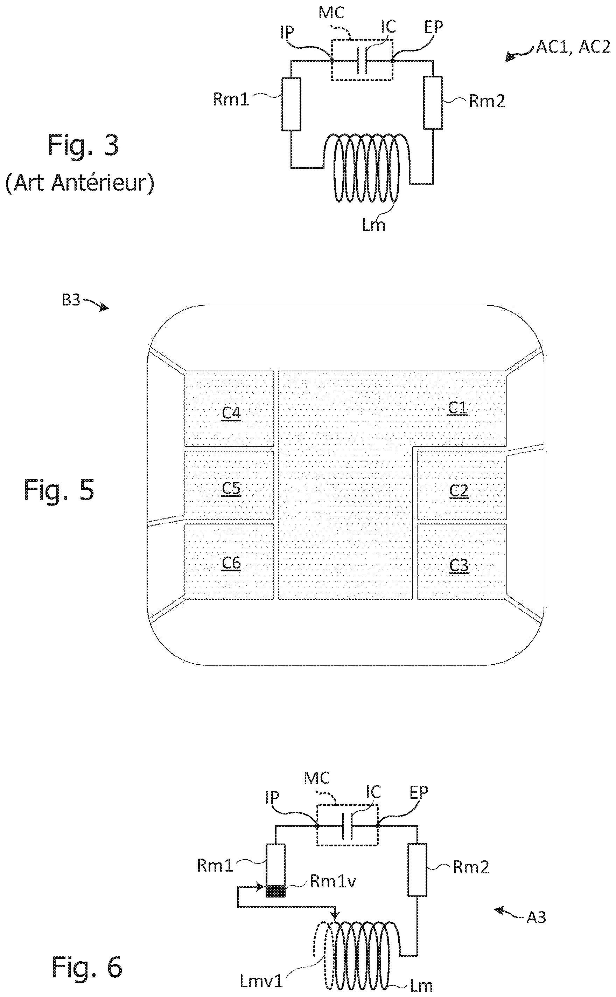

Comme montré sur la figure 3, une telle bobine d'antenne A1 ou A2, une fois connectée aux bornes du microcircuit MC, forme, avec un condensateur interne IC du microcircuit, un circuit résonant RLC devant être ajusté à une fréquence de résonance déterminée, avec :
- « C » la capacité d'un condensateur d'antenne interne au microcircuit MC,
- « R » la valeur d'une résistance série Rm de la bobine d'antenne, telle que vue par le microcircuit. Cette résistance série est schématisée sur la figure par deux résistances Rm1, Rm2 en série,
- « L » la valeur d'une inductance Lm de la bobine d'antenne, telle que vue par le microcircuit.

La configuration et l'optimisation d'un module sans contact nécessite de concevoir la bobine d'antenne de manière à obtenir une certaine valeur du circuit résonant RLC, et cette valeur peut dépendre de la carte dans laquelle le module doit être inséré et de l'application visée pour cette carte. La conception de la bobine d'antenne pour obtenir les valeurs L et R souhaitées en tenant compte de la capacité C du microcircuit fait intervenir des outils de simulation utilisant différentes variables, notamment :
- le nombre de spires et la longueur des spires de la bobine d'antenne, pour une surface du module imposée par un cahier des charges,
- la distance interspire et la largeur des spires, la somme de ces deux valeurs formant ce qu'il est commun d'appeler le pas technologique ou « pitch » de la bobine d'antenne, et
- l'épaisseur de la couche conductrice et donc l'épaisseur des spires.

La résistance Rm est un paramètre résultant qui dépend de la longueur des spires qui composent la bobine d'antenne, de leur largeur et de leur épaisseur, et est égal au produit de la résistivité de la couche conductrice dans laquelle les spires sont gravées par la longueur des spires divisé par leur section en coupe. Des paramètres contraignants sont imposés par des règles de gravure des spires (« contraintes process ») et de conduction minimale des spires (« contraintes électriques »). En particulier l'épaisseur des spires doit être supérieure à l'épaisseur de peau du matériau qui les compose, par exemple 18 micromètres avec spires en cuivre et une fréquence de travail de 13.56MHz. Par ailleurs la capacité C du condensateur d'antenne CI intégré dans le microcircuit MC est susceptible de varier en fonction du microcircuit utilisé et de l'application visée.

Il peut donc se produire que la structure de bobine d'antenne classique qui vient d'être décrite ne permette pas d'ajuster finement les valeurs de L et de R en faisant seulement varier le nombre de spires, pour un pas technologique et une épaisseur des spires prédéterminés. Il pourrait donc être souhaité de perfectionner une telle structure de bobine d'antenne d'une manière permettant d'ajuster plus finement son inductance au stade de sa conception.

Dans d'autres cas, il peut être souhaité de prévoir une structure de bobine d'antenne pouvant être utilisée avec plusieurs types de microcircuits MC dont la capacité interne C est susceptible de varier dans de larges proportions. Plusieurs structures de bobines d'antenne et plusieurs types de modules doivent alors être fabriqués, ce qui augmente le prix de revient de la production d'un ensemble de modules. Il pourrait donc être souhaité de prévoir une structure de bobine d'antenne configurable utilisable avec des microcircuits différents, pour réduire les frais de conception et de fabrication.

### EXPOSÉ DE L'INVENTION

La présente invention concerne un procédé de fabrication d'un module sans contact, comprenant des étapes consistant à : déposer une première couche électriquement conductrice sur une première face d'une plaquette, former une bobine d'antenne par gravure de la première couche, la bobine d'antenne comportant des spires de rangs croissants en allant de l'extérieur vers l'intérieur de la bobine d'antenne, dont une spire extérieure de rang 1 et une spire intérieure de rang N, la spire intérieure étant reliée à une plage de connexion intérieure et la spire extérieure reliée à une plage de connexion extérieure, fixer un microcircuit sur la première face de la plaquette, dans une zone centrale de la bobine d'antenne délimitée par une spire de la bobine d'antenne, et relier des premières bornes de connexion du microcircuit à des plages de connexion de la bobine d'antenne, par l'intermédiaire de fils. La première couche est gravée de manière que les plages de connexion extérieure et intérieure de la bobine d'antenne soient formées dans la zone centrale de la bobine d'antenne, la bobine d'antenne comprenant une zone de contournement dans laquelle chaque spire contourne la plage de connexion extérieure par la zone centrale. La première couche est gravée de manière que la bobine d'antenne comprend un premier groupe de spires de rangs 1 à E, présentant sensiblement la même distance interspire, la spire de rang E étant la spire intérieure du premier groupe de spires, E étant au moins égal à 4. La zone centrale est délimitée par le contour de la spire intérieure du premier groupe de spires, et la bobine d'antenne comprend un second groupe d'au moins deux spires de rangs E+1 à N, qui s'étend à l'intérieur de la zone centrale, chaque spire du second groupe de spires comprenant des portions de spires qui se trouvent à des distances variables de la spire de rang précédent, lesdites distances étant comprises entre ladite distance interspire et plusieurs fois la distance interspire.

Selon un mode de réalisation, le procédé comprend des étapes consistant à déposer une seconde couche électriquement conductrice sur une seconde face de la plaquette, former dans la seconde couche des plages de contact, et former deux rangées de deux ou trois trous chacune dans la plaquette, jusqu'à atteindre les plages de contact de la seconde couche, les rangées de trous étant sensiblement perpendiculaires à un axe longitudinal du module, et la première couche est gravée de manière que tout ou partie des spires du second groupe suivent un chemin qui passe entre au moins deux trous d'au moins une rangée de trous.

Selon un mode de réalisation, le microcircuit est supporté en tout ou en partie par au moins la spire intérieure de la bobine d'antenne et peut également être supporté par au moins une portion de spire du premier groupe de spires s'étendant dans la zone de contournement.

Selon un mode de réalisation, la couche conductrice est gravée de manière à comporter une structure support pour supporter tout ou partie du microcircuit, la structure support étant reliée électriquement à la spire intérieure de la bobine d'antenne.

Selon un mode de réalisation, au moins une partie de la structure support forme un chemin conducteur faisant partie de la spire intérieure de la bobine d'antenne.

Selon un mode de réalisation, la couche conductrice est gravée de manière à former, dans la zone de contournement, au moins une plage de connexion à une spire de rang supérieur à 1 du premier groupe de spires.

Selon un mode de réalisation, le procédé comprend une étape consistant à relier une première des premières bornes de connexion du microcircuit à la plage de connexion d'une spire de rang supérieur à 1 du premier groupe de spires.

Selon un mode de réalisation, la couche conductrice est gravée de manière à former, dans la zone centrale, au moins une plage de connexion à une spire de rang inférieur à N du second groupe de spires.

Selon un mode de réalisation, le procédé comprend une étape consistant à relier une seconde des premières bornes de connexion du microcircuit à la plage de connexion d'une spire de rang inférieur à N du second groupe de spires.

Selon un mode de réalisation, le procédé comprend une étape de dépôt d'une couche de protection électriquement isolante sur le microcircuit et les fils de connexion.

Selon un mode de réalisation, la plaquette appartient à une plaque dans laquelle sont formés collectivement plusieurs modules sans contact, le procédé comprenant une étape de découpe de la plaque pour individualiser les modules, effectuée après connexion de chaque microcircuit.

Selon un mode de réalisation, le procédé comprend une étape de conception de la bobine d'antenne comprenant une étape de détermination d'au moins une valeur cible de l'inductance et d'une valeur cible de la résistance de la bobine d'antenne telles que devant être vues depuis les premières bornes de connexion du microcircuit, une étape de conception du premier groupe de spires et du second groupe de spires de manière que l'inductance et la résistance de la bobine d'antenne telles que vues depuis des plages de connexion de la bobine d'antenne soient proches des valeurs cibles visées.

Selon un mode de réalisation, le procédé comprend une étape de conception de la bobine d'antenne comprenant une étape de détermination d'une pluralité de valeurs cibles de l'inductance et de valeurs cibles de la résistance de la bobine d'antenne telles que devant être vues depuis les premières bornes de connexion du microcircuit, une étape de conception du premier groupe de spires et du second groupe de spires, comprenant la prévision de plusieurs plages de connexion à des spires de rangs différents du premier groupe de spires et/ou du second groupe de spires, de telle sorte que la bobine d'antenne présente plusieurs paires de plages de connexion, chaque paire de plages de connexion comprenant une plage de connexion à une spire du premier groupe de spires et une plage de connexion à une spire du second groupe de spires, la conception du premier groupe et du second groupe de spires et le choix de l'emplacement des bornes de connexion étant faits de manière à ce que l'inductance et la résistance de la bobine d'antenne telles que vues depuis chaque paire de plages de connexion de la bobine d'antenne soient proches de l'une des valeurs de la pluralité de valeurs cibles de l'inductance et de valeurs cibles de la résistance de la bobine d'antenne.

L'invention concerne également un procédé de fabrication d'une carte à microcircuit comprenant des étapes consistant à exécuter le procédé précédemment décrit, pour obtenir un module sans contact, former une bobine d'antenne dans une carte, et implanter le module dans la carte, la bobine d'antenne de la carte présentant au moins une spire proche de la bobine d'antenne du microcircuit pour établir un couplage inductif entre les deux bobines d'antenne.

L'invention concerne également un module sans contact, comprenant une plaquette recouverte sur une première face d'une première couche électriquement conductrice dans laquelle est formée une bobine d'antenne, la bobine d'antenne comportant des spires de rangs croissants en allant de l'extérieur vers l'intérieur de la bobine d'antenne, dont une spire extérieure de rang 1 et une spire intérieure de rang N, la spire intérieure étant reliée à une plage de connexion intérieure et la spire extérieure reliée à une plage de connexion extérieure, un microcircuit fixé sur la première face de la plaquette, dans une zone centrale de la bobine d'antenne délimitée par une spire de la bobine d'antenne, et comportant des premières bornes de connexion reliées à des plages de connexion de la bobine d'antenne par l'intermédiaire de fils, les plages de connexion extérieure et intérieure de la bobine d'antenne étant formées dans la zone centrale de la bobine d'antenne. La bobine d'antenne comprend une zone de contournement dans laquelle chaque spire contourne la plage de connexion extérieure par la zone centrale, un premier groupe de spires de rangs 1 à E présentant sensiblement la même distance interspire, la spire de rang E étant la spire intérieure du premier groupe de spires, E étant au moins égal à 4, la zone centrale étant délimitée par le contour de la spire intérieure du premier groupe de spires. La bobine d'antenne comprend également un second groupe d'au moins deux spires de rangs E+1 à N, qui s'étend à l'intérieur de la zone centrale, chaque spire du second groupe de spires comprenant des portions de spires qui se trouvent à des distances variables de la spire de rang précédent, lesdites distances étant comprises entre ladite distance interspire et plusieurs fois la distance interspire.

Selon un mode de réalisation, la plaquette comprend des plages de contact sur une seconde face de la plaquette, deux rangées de deux ou trois trous chacune pratiquées dans la plaquette, atteignant les plages de contact sur la seconde face, les rangées de trous étant sensiblement perpendiculaires à un axe longitudinal du module, et tout ou partie des spires du second groupe de spires suivent un chemin qui passe entre au moins deux trous d'au moins une rangée de trous.

Selon un mode de réalisation, le microcircuit est supporté en tout ou en partie par au moins la spire intérieure de la bobine d'antenne et peut être également supporté par au moins une portion de spire du premier groupe de spires s'étendant dans la zone de contournement.

Selon un mode de réalisation, la couche conductrice comporte une structure support pour supporter tout ou partie du microcircuit, la structure support étant reliée électriquement à la spire intérieure de la bobine d'antenne.

Selon un mode de réalisation, au moins une partie de la structure support forme un chemin conducteur faisant partie de la spire intérieure de la bobine d'antenne.

Selon un mode de réalisation, la bobine d'antenne comprend, dans la zone de contournement, au moins une plage de connexion à une spire de rang supérieur à 1 du premier groupe de spires.

Selon un mode de réalisation, une première des premières bornes de connexion du microcircuit est reliée à la plage de connexion d'une spire de rang supérieur à 1 du premier groupe de spires.

Selon un mode de réalisation, la bobine d'antenne comprend, dans la zone centrale, au moins une plage de connexion à une spire de rang inférieur à N du second groupe de spires, à laquelle est connectée ou peut être connectée une seconde des premières bornes de connexion du microcircuit.

L'invention concerne également un carte à microcircuit comprenant une bobine d'antenne et un module sans contact tels que décrits précédemment, la bobine d'antenne de la carte présentant au moins une spire proche de la bobine d'antenne du module, pour établir un couplage inductif entre les deux bobines d'antenne.

### BREVE DESCRIPTION DES FIGURES

Des exemples de réalisation de modules sans contact et de procédés de fabrication de tels modules sans contact seront décrits dans ce qui suit à titre non limitatif, en relation avec les figures jointes parmi lesquelles :
[Fig. 1] la figure 1 précédemment décrite montre un module sans contact classique,
[Fig. 2] la figure 2 précédemment décrite montre un autre module sans contact classique,
[Fig. 3] la figure 3 est le schéma électrique d'un circuit d'antenne du module sans contact de la figure 1 ou de la figure 2,
[Fig. 4A] la figure 4A montre la face arrière d'un premier mode de réalisation d'une plaquette de module sans contact,
[Fig. 4B] la figure 4B montre la face arrière d'un module sans contact formé à partir de la plaquette de la figure 4A,
[Fig. 5] la figure 5 montre la face avant de la plaquette de la figure 4A,
[Fig. 6] la figure 6 est le schéma électrique d'un circuit d'antenne du module sans contact de la figure 4B,
[Fig. 7A] la figure 7A montre la face arrière d'une variante de la plaquette de la figure 4A,
[Fig. 7B] la figure 7B montre la face arrière d'un module sans contact formé à partir de la plaquette de la figure 7A,
[Fig. 8A] la figure 8A montre la face arrière d'une autre variante de la plaquette de la figure 4A,
[Fig. 8B] la figure 8B montre la face arrière d'un module sans contact formé à partir de la plaquette de la figure 8A,
[Fig. 9A] la figure 9A montre la face arrière d'encore une autre variante de la plaquette de la figure 4A,
[Fig. 9B] la figure 9B montre la face arrière d'un module sans contact formé à partir de la plaquette de la figure 9A,
[Fig. 10] la figure 10 montre la face arrière d'encore une autre variante de la plaquette de la figure 4A,
[Fig. 11A] [Fig. 11B] les figures 11A, 11B sont identiques et montrent la face arrière d'un second mode de réalisation d'une plaquette de module sans contact,
[Fig. 11C] la figure 11C montre la face arrière d'un module sans contact formé à partir de la plaquette de la figure 11A,
[Fig. 11D] la figure 11D montre la face arrière d'un autre module sans contact formé à partir de la plaquette de la figure 11A,
[Fig. 12] la figure 12 montre la face avant de la plaquette de la figure 11A,
[Fig. 13] la figure 13 est le schéma électrique d'un circuit d'antenne du module sans contact de la figure 11C ou de la figure 11D,
[Fig. 14] la figure 14 montre la face arrière d'une variante de la plaquette de la figure 11A,
[Fig. 15] la figure 15 montre la face arrière d'une autre variante de la plaquette de la figure 11A,
[Fig. 16] la figure 16 montre la face arrière d'encore une autre variante de la plaquette de la figure 11A,
[Fig. 17] la figure 17 montre la face arrière d'encore une autre variante de la plaquette de la figure 11A,
[Fig. 18] la figure 18 montre la face arrière d'encore une autre variante de la plaquette de la figure 11A,
[Fig. 19A] [Fig. 19B] les figures 19A, 19B montrent une étape d'un procédé de fabrication d'une plaquette de module sans contact,
[Fig. 20] la figure 20 montre une carte équipée d'un module sans contact,
[Fig. 21] la figure 21 est une vue en coupe de la carte à puce de la figure 20.

### DESCRIPTION DETAILLEE

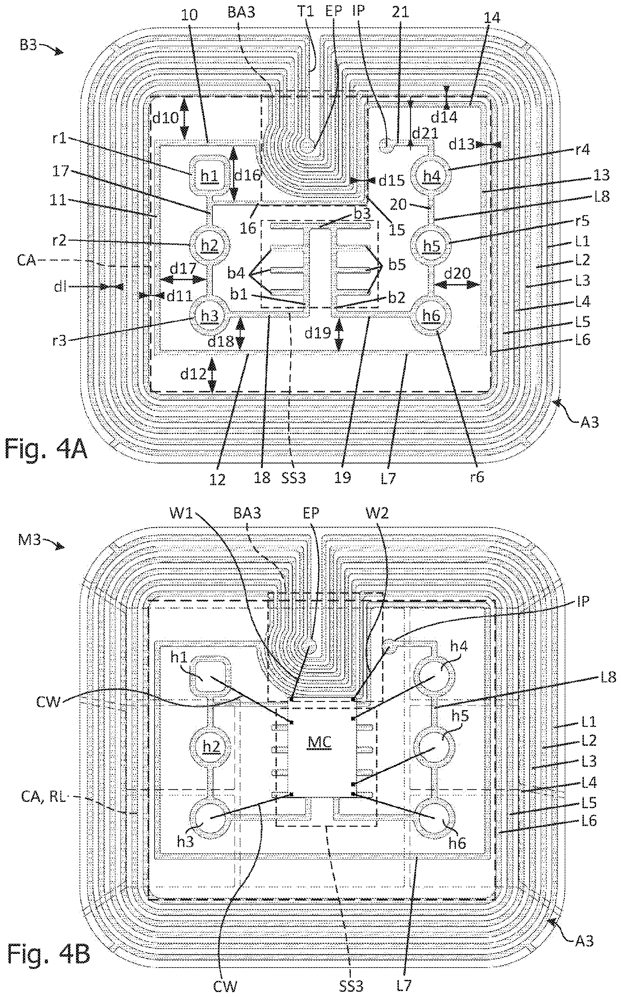

La figure 4A montre la face arrière d'une plaquette B3 de module sans contact et la figure 5 montre la face avant de la plaquette B3. La plaquette est en un matériau électriquement isolant, par exemple de l'époxy, comprenant une face avant et une face arrière. Chaque face est recouverte d'une couche conductrice, désignées ci-après « couche conductrice avant » et « couche conductrice arrière ». La couche conductrice arrière a été gravée pour former une bobine d'antenne A3 (Fig. 4A) et la couche conductrice avant a été gravée pour former des plages de contact C1-C6 (Fig. 5). L'épaisseur de la plaquette B3 est par exemple de l'ordre de la centaine de micromètres et ses dimensions sont par exemple de l'ordre de 13 x 11,8 mm. Les deux couches conductrices sont par exemple en cuivre. Dans certains modes de réalisation, le cuivre peut être recouvert d'une couche de finition en nickel, or, ou palladium ou une superposition de ces matériaux. Le nickel est généralement utilisé pour éviter l'oxydation du cuivre. L'or est généralement utilisé pour améliorer la conductivité électrique des couches conductrices. Le palladium peut être utilisé pour améliorer l'aspect visuel de la couche conductrice en face avant (aspect argenté). La combinaison cuivre/nickel/or est celle la plus généralement utilisée dans l'industrie et plus rarement la combinaison cuivre/nickel/or/palladium. De façon générale, la plaquette B3, ainsi que toutes les plaquettes décrites dans ce qui suit, peuvent être réalisées au moyen de toute technologie actuelle ou future de dépôt de couche conductrice sur un support rigide ou flexible, et de gravure de la couche conductrice. Un procédé de fabrication collective d'une pluralité de plaquettes sera notamment décrit plus loin.

Les plages de contact C1 à C6 (figure 5) en face avant sont par exemple des plages de contact conformes à la norme ISO 7816, et comprennent cinq plages de contact actives (Vcc, Clock, GND, RST, I/O) et une plage de contact réservée à usage futur (RFU) ou spécifique à certaines applications. La plaquette M comporte également des trous h1 à h6 réalisés depuis la face arrière et débouchant sur la face arrière des plages de contact C1 à C6 en face avant, sans les traverser. Ces trous peuvent être formés avant ou après dépôt des couches conductrices. Ils forment deux rangées h1, h2, h3, respectivement h4, h5, h6 de trois trous chacune. Selon le procédé de fabrication utilisé, la face arrière de la plaquette B3 peut comporter des collerettes conductrices, ou anneaux conducteurs r1 à r6, qui s'étendent autour des trous h1 à h6 et sont formées au cours de l'étape de gravure de la couche conductrice arrière pour former la bobine d'antenne A3.

La bobine d'antenne A3 (figure 4A) présente une structure conforme à un premier perfectionnement et sera maintenant décrite en détail. La bobine d'antenne A3 comporte N spires de rang croissant en allant de l'extérieur vers l'intérieur de la bobine d'antenne, ici 8 spires L1 à L8, soit N=8. La spire L1 de rang 1 est la spire extérieure et la spire L8 de rang 8 est la spire intérieure de la bobine d'antenne. La spire intérieure L8 est reliée à une plage de connexion intérieure IP et la spire extérieure L1 reliée à une plage de connexion extérieure EP. Conformément à l'enseignement de WO 2014/006286 A1, les plages de connexion EP, IP sont formées dans une zone centrale CA de la bobine d'antenne, la bobine d'antenne comprenant une zone de contournement BA3 dans laquelle chaque spire L1 à L8 contourne la plage de connexion extérieure EP par la zone centrale CA. La spire extérieure L1 suit la totalité du contour de bobine d'antenne à l'exception d'une zone permettant le passage d'une piste conductrice T1 reliant la plage de connexion extérieure EP à la spire extérieure L1. On distingue ainsi, dans une telle structure de bobine d'antenne A3, le « contour » de la bobine d'antenne, qui est défini par la forme générale de la spire extérieure L1 sans tenir compte de la zone de contournement BA3, et « l'extérieur » de la spire extérieure L1, qui inclut la piste T1 reliant la spire extérieure L1 à la plage de connexion extérieure EP. La zone de contournement BA3 et la zone centrale CA sont montrées par des traits pointillées sur la figure 4A. La zone de contournement BA3 s'étend dans la zone centrale CA qui inclut les bornes de connexion EP, IP de la bobine d'antenne.

Optionnellement, la plaquette B3 comprend également une structure support SS3 pour assurer la planéité du montage d'un microcircuit sur la plaquette. La structure support SS3 est ici sensiblement en forme de « π » et comprend une première branche b1 et une deuxième branche b2 parallèles entre elles, et une troisième branche b3 transversale reliant les branches b1, b2. Elle comporte également trois branches b4 parallèles à la branche b3 et rattachées à la branche b1, et trois branches b5 parallèles à la branche b3 et rattachées à la branche b2. Les branches b1, b2 et la partie de la branche b3 qui relie les branches b1, b2 font ici partie intégrante du chemin conducteur formant la spire intérieure L8.

Selon le premier perfectionnement, la bobine d'antenne :
- comprend un premier groupe de spires de rangs 1 à E, ici les spires L1 à L6, soit E=6, présentant sensiblement la même distance interspire dl, la spire de rang E, soit ici la spire L6, étant la spire intérieure du premier groupe de spires,
- la zone centrale CA de la bobine d'antenne est délimitée par le contour de la spire intérieure de rang E du premier groupe de spires, soit ici la spire L6. Par « délimitée par le contour de la spire intérieure de rang E », on désigne le fait que la zone centrale est délimitée par la forme globale de la spire de rang E, en faisant abstraction de la zone de contournement, qui s'étend à l'intérieur de la zone centrale et comprend donc des portions de spires du premier groupe de spires appartenant à la zone de contournement.
- la bobine d'antenne comprend un second groupe d'au moins deux spires de rangs allant de E+1 à N, E+1 étant ici égal à 7, qui s'étendent à l'intérieur de la zone centrale CA. Le second groupe de spires comprend ici les spires L7 et L8.
- chaque spire du second groupe de spires, ici L7 et L8, comprend des portions de spires qui se trouvent à des distances variables de la spire de rang précédent, soit ici la spire L6 pour la spire L7 et la spire L7 pour la spire L8. Ces distances sont comprises entre la distance interspire et plusieurs fois la distance interspire dl du premier groupe de spires.

Dans cet exemple, la spire L7 comprend des portions de spires 10 à 14. La portion 10 comprend un tronçon de piste conductrice courbe appartenant à la zone de contournement BA3 suivi d'un tronçon de piste rectiligne qui s'éloigne de la zone de contournement et se trouve à une distance d10 de la spire L6. La portion 11 est un tronçon de piste rectiligne perpendiculaire au tronçon 10 et se trouvant à une distance d11 de la spire L6. La portion 12 est un tronçon de piste rectiligne perpendiculaire au tronçon 11 et se trouvant à une distance d12 de la spire L6. La portion 13 est un tronçon de piste rectiligne perpendiculaire au tronçon 12 et se trouvant à une distance d13 de la spire L6. La portion 14 est un tronçon de piste rectiligne perpendiculaire au tronçon 13 et se trouvant à une distance d14 de la spire L6. La portion 15 est un tronçon de piste rectiligne perpendiculaire au tronçon 14 et se trouvant à une distance d15 de la spire L6. Les distances d11, d13, d14 et d15 sont égales à la distance interspire dl du premier groupe de spires. Les distances d10 et d12 sont plusieurs fois supérieures à la distance dl.

La spire L8 comprend des portions 16 à 21. La portion 16 est un tronçon de piste rectiligne s'éloignant de la zone de contournement, jusqu'à se trouver à distance d16 de la portion 10 de la spire L7. La portion 17 comprend un tronçon de piste rectiligne se trouvant à une distance d17 de la portion 11 de la spire L7, et deux anneaux conducteurs r2 et r3 entourant les trous h2 et h3. La portion 18 est un tronçon de piste rectiligne se trouvant à une distance d18 de la portion 12 de la spire L7 et qui est rattaché à la branche b1 de la structure support SS3. La portion 19 est un tronçon de piste rectiligne se trouvant à une distance d19 égale à d18 de la portion 12 de la spire L7 et rattaché à la branche b2 de la structure support SS3. La portion 20 comprend trois tronçons de pistes rectilignes se trouvant à une distance d20 de la portion 13 de la spire L7, et trois anneaux conducteurs r4, r5, r6 s'étendant autour des trous h4, h5, h6. La portion 21 est un tronçon de piste rectiligne se trouvant à une distance d21 de la portion 14 de la spire L7, se terminant par la borne de connexion intérieure IP de la bobine d'antenne. Les distances d16, d17, d18, d19, d20 et d21 sont chacune plusieurs fois supérieures à la distance interspire dl. La bordure du trou h1 comprend également un anneau conducteur r1 rattaché à la portion 16 mais ne faisant pas partie du chemin conducteur de la spire L8. Comme indiqué plus haut, les branches b1, b2 et la partie de la branche b3 qui relie les branches b1, b2 de la structure support SS3 font ici partie intégrante de la spire L8.

La figure 4B montre un module sans contact M3 réalisé à partir de la plaquette B3. Un microcircuit MC a été fixé sur la plaquette au moyen d'une colle électriquement isolante. Des premières bornes de connexion du microcircuit, ou bornes de connexion d'antenne, ont été reliées par des fils W1, W2 aux plages de connexion EP, IP de la bobine d'antenne A3. Des secondes bornes de connexion du microcircuit, ou bornes de connexion du mode contact, ont été reliées aux plages de contact C1, C3 à C6 en face avant (Fig. 5) par des fils CW passant dans les trous h1, h3 à h6 qui atteignent la face arrière de ces contacts sans les traverser. Le microcircuit MC repose sur une partie de la longueur et toute sa largeur sur la structure support SS3 et sur une autre partie de sa longueur et toute sa largeur sur des portions de spires dans la zone de contournement, ici une portion de la spire L7 et la portion 1 de la spire L8. La zone centrale CA de la bobine d'antenne A3, délimitée ici par le contour de la spire L6, a été recouverte d'une couche de résine RL assurant la protection mécanique des fils. En pratique et en fonction des tolérances du procédé d'encapsulation, cette couche de résine peut ne pas coïncider exactement avec la zone centrale CA, et peut comprendre une bordure de sécurité qui déborde sur une ou plusieurs spires du premier groupe de spires.

Selon le présent perfectionnement, les spires du second groupe de spires, ici L7, L8, présentent une forme complexe pouvant varier au gré du concepteur, offrant une marge de manœuvre supplémentaire dans la conception de la bobine d'antenne pour ajuster finement son inductance à une valeur désirée, tout en ajustant la valeur de sa résistance série. Comme montré sur la figure 6, une fois connectée au microcircuit, la bobine d'antenne A3 forme, avec un condensateur interne IC du microcircuit MC, un circuit résonant RLC pouvant être ajusté à une fréquence de résonance déterminée, avec :
- « C » la capacité d'un condensateur interne du microcircuit MC (condensateur d'antenne),
- « R » la valeur d'une résistance série Rm de la bobine d'antenne, telle que vue par le microcircuit, schématisée par deux résistances Rm1, Rm2 en série,
- « L » la valeur d'une inductance Lm de la bobine d'antenne, telle que vue par le microcircuit.

On a représenté par Lmv1 la partie de l'inductance de la bobine d'antenne qu'il est possible de faire varier en fonction de la forme conférée aux spires L7, L8, et par Rm1v la partie de la résistance de la bobine d'antenne qu'il est possible de faire varier en fonction de la forme conférée aux spires L7, L8. La conception des spires L7, L8, et de façon générale des spires du second groupe, offre donc un degré de liberté supplémentaire pour l'obtention d'une valeur souhaitée du circuit résonant RLC, en sus des variables classiques de conception telle que le nombre de spires et la longueur des spires du premier groupe de spires, la distance interspire et la largeur des spires, l'épaisseur de la couche conductrice et donc l'épaisseur des spires, etc.

La figure 4B montre un module sans contact M3 réalisé à partir de la plaquette B3. Un microcircuit MC a été fixé sur la plaquette. Les premières bornes de connexion du microcircuit ont été reliées par des fils W1, W2 aux plages de connexion EP, IP de la bobine d'antenne A3. Les secondes bornes de connexion du microcircuit ont été reliées par des fils CW passant dans les trous h1, h3 à h6 aux plages de contact C1, C3 à C6 en face avant (Fig. 5). Le microcircuit repose sur une partie de la longueur et toute sa largeur sur la structure support SS3 et sur une autre partie de sa longueur et toute sa largeur sur des portions de spires dans la zone de contournement, ici une partie de la portion 10 de la spire L7 et une partie de la portion 16 de la spire L8. La zone centrale CA de la bobine d'antenne A3, délimitée ici par le contour de la spire L6, est recouverte d'une couche de résine RL assurant la protection mécanique des fils. Comme indiqué plus haut, cette couche de résine peut ne pas coïncider exactement avec la zone centrale CA, et peut comprendre une bordure de sécurité.

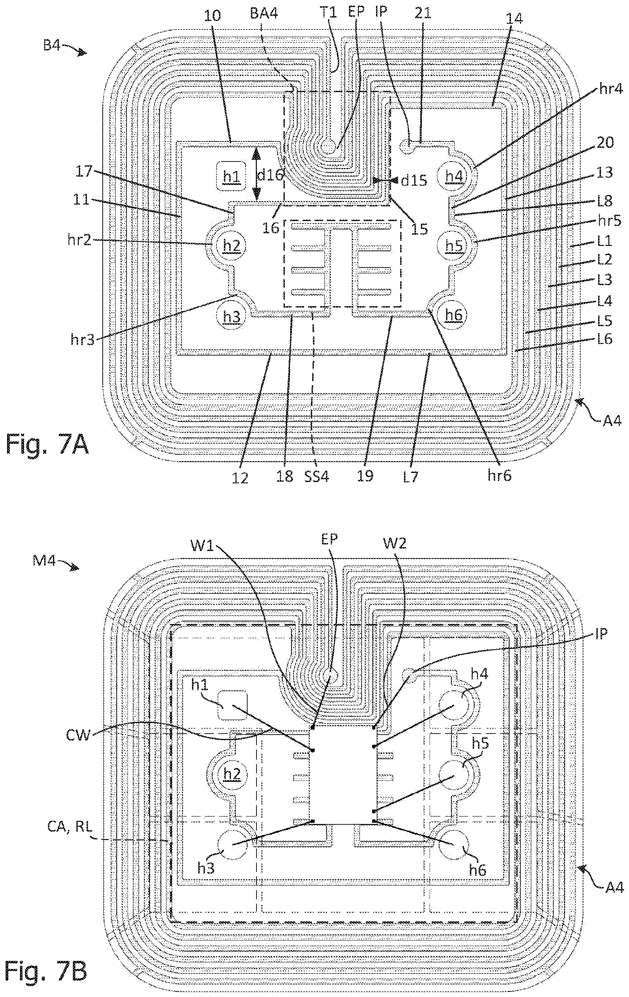

La figure 7A montre une variante B4 de la plaquette B3 comprenant une bobine d'antenne A4 de même structure générale que la bobine d'antenne A3, avec une structure support SS4 identique à la structure support SS3 et une zone de contournement BA4 identique à la zone de contournement BA3. La bobine d'antenne A4 se distingue de la bobine d'antenne A3 en ce que la périphérie des trous h1 à h6 est dépourvue d'anneaux conducteurs. Dans ce cas, la portion 17 de la spire L8 comprend, à la place des anneaux conducteurs, un tronçon de piste en demi-cercle hr2 qui contourne le trou h2, et un tronçon de piste hr3 en quart de cercle qui contourne le trou h3. De même, la portion 20 de la spire L8 comprend un tronçon de piste conductrice hr6 en quart de cercle qui contourne le trou h6, un tronçon de piste hr5 en demi- cercle qui contourne le trou h5, et un tronçon de piste hr4 en demi-cercle qui contourne le trou h4.

Un module sans contact M4 réalisé avec la plaquette B4 est montré sur la figure 7B. Le module sans contact M4 est identique au module sans contact M3 aux différences près qui viennent d'être indiquées, et la description ci-dessus du module sans contact M3 s'applique au module sans contact M4.

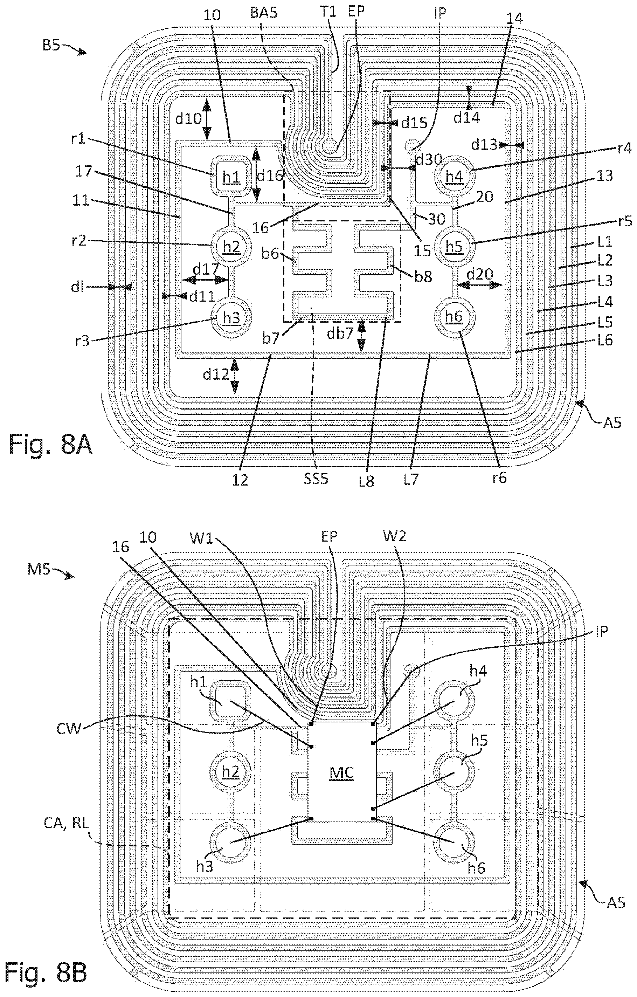

La figure 8A montre une variante B5 de la plaquette B3, comprenant une bobine d'antenne A5 dans laquelle le premier groupe de spires comprend des spires L1 à L6 et le second groupe de spires comprend des spires L7 et L8. Les spires L1 à L6 du premier groupe, et la spire L7 du second groupe, sont identiques aux spires L1 à L7 de la bobine d'antenne A3 de la plaquette B3 et la zone de contournement BA5 identique à la zone de contournement BA3.

La plaquette B5 comprend ici une structure support SS5 comprenant des branches b6, b7, b8, les branches b6 et b8 étant en forme de créneau et la branche b7 reliant les branches b6 et b8.

La spire L7 comprend les portions de spires 10 à 15 déjà décrites. La spire L8 comprend la portion 16 déjà décrite, les branches b6, b7, b8 de la structure support SS5 et une portion de spire 30. La portion 16 est rattachée à une terminaison de la branche b6, et la portion 30 est un tronçon de piste rectiligne rattaché à une terminaison de la branche b8, qui se termine par la plage de connexion intérieure IP de la bobine d'antenne.

La plaquette B5 comprend également la portion 17 et les anneaux conducteurs r1, r2, r3 précédemment décrits, qui sont reliés à la portion 16, mais ne font plus ici partie du chemin conducteur de la spire L8. De même, la portion 20 et les anneaux conducteurs r4, r5, r6 précédemment décrits sont reliés à la portion 30 mais ne font plus ici partie du chemin conducteur de la spire L8.

La figure 8B montre un module sans contact M5 réalisé à partir de la plaquette B5. Comme précédemment les premières bornes de connexion d'un microcircuit MC ont été reliées par des fils W1, W2 aux plages de connexion EP, IP de la bobine d'antenne A5, et des secondes bornes de connexion du microcircuit ont été reliées par des fils passant dans les trous h1, h3 à h6 aux plages de contact C1, C3 à C6 en face avant (Fig. 5). Le microcircuit repose sur une partie de la longueur et toute sa largeur sur la structure support SS5 et sur une autre partie de sa longueur et toute sa largeur sur une partie de la portion 16 de la spire L8 et une partie de la portion 10 de la spire L7. La zone centrale CA de la bobine d'antenne A5, délimitée ici par le contour de la spire L6, a été recouverte d'une couche de résine RL assurant la protection mécanique des fils.

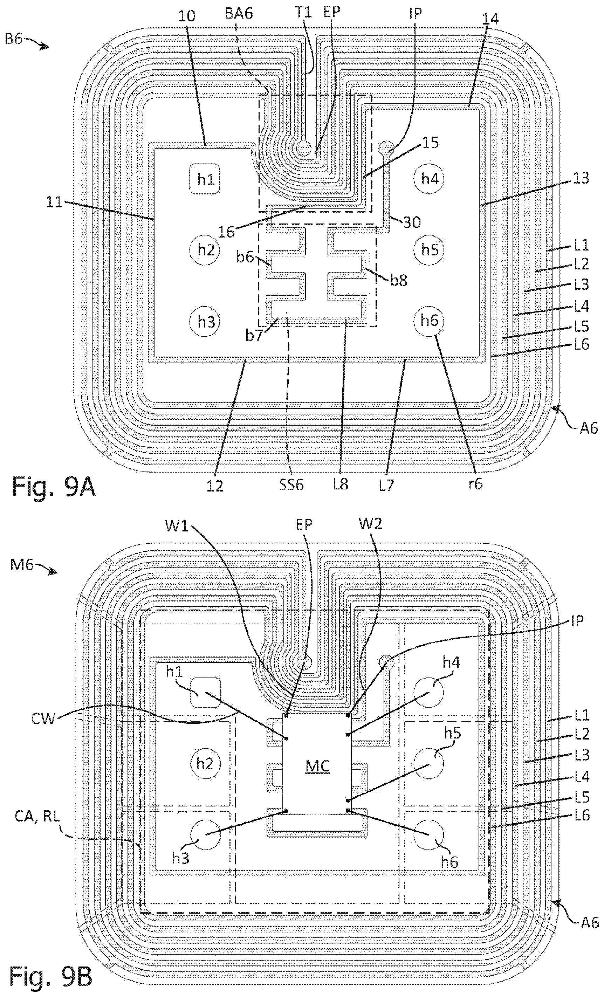

La figure 9A montre une variante B6 de la plaquette B5 comprenant une bobine d'antenne A6 de même structure générale que la bobine d'antenne A5, avec une structure support SS6 identique à la structure support SS5 et une zone de contournement BA6 identique à la zone de contournement BA5. La plaquette B6 se distingue de la plaquette B5 en ce que la périphérie des trous h1 à h6 est dépourvue d'anneaux conducteurs. Dans ce cas, la portion 17 et les anneaux conducteurs r1, r2, r3, et la portion 20 et les anneaux conducteurs r4, r5, r6, précédemment décrits comme ne faisant pas partie du chemin conducteur de la spire L8, sont supprimés.

Un module sans contact M6 réalisé avec la plaquette B6 est montré sur la figure 9B. Le module sans contact M6 est identique au module sans contact M5 aux différences près qui viennent d'être indiquées, et la description ci-dessus du module sans contact M5 s'applique au module sans contact M6.

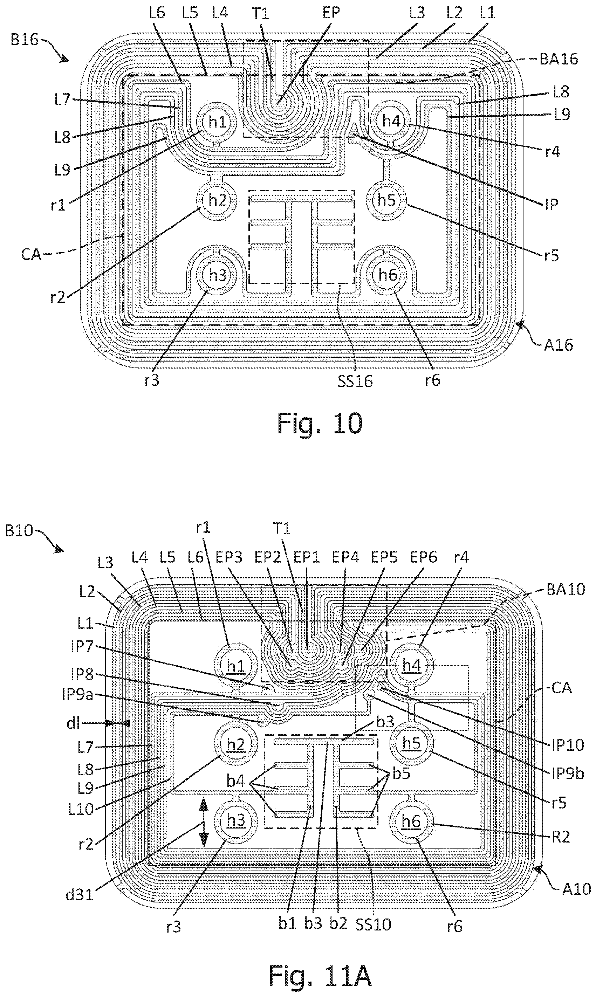

Une bobine d'antenne selon le premier perfectionnement est susceptible de diverses variantes autres que celles décrites dans ce qui précède. A titre d'illustration, la figure 10 montre un exemple d'application du premier perfectionnement à une plaquette B16 ayant des dimensions de l'ordre de 11 x 8,32 mm. La plaquette B16 comprend une bobine d'antenne A16 comprenant un premier groupe de spires L1 à L5 espacées de la distance interspire dl décrite plus haut, un second groupe de spires comprenant des spires L6 à L9 présentant des distances variables relativement aux spires de rangs précédents, une structure support SS16 sensiblement en forme de « π » du type décrit plus haut. La plaquette B16 comprend également des anneaux conducteurs r1 à r6 s'étendant autour des trous h1 à h6, les trous h1 à h6 formant une première rangée de trous h1 à h3 et une seconde rangée de trous h4 à h6, chaque rangée étant perpendiculaire à un axe longitudinal du module. Dans certains modes de réalisation, les trous peuvent ne pas être parfaitement alignés. Leur axe d'alignement peut alors être défini comme un axe qui passe au plus près du centre de chaque trou. Cet axe peut ne pas être parfaitement perpendiculaire à l'axe longitudinal du module, et l'on comprendra donc l'expression « perpendiculaire » comme signifiant « sensiblement perpendiculaire ». Dans le cas d'un module de forme sensiblement carrée, l'axe longitudinal du module sera défini comme étant un axe perpendiculaire à un axe longitudinal du microcircuit MC, les rangées de trous étant donc parallèles à l'axe longitudinal du microcircuit, ou sensiblement parallèles à cet axe.

Selon un aspect optionnel mais avantageux du premier perfectionnement, applicable notamment à un module comprenant les trous précédemment décrits, les spires L6, L7, L8 s'éloignent de la spire L5 après la zone de contournement BA16 pour passer entre les trous h1 et h2 et leurs anneaux conducteurs r1, r2, puis reviennent à proximité de la spire L6 avec une distance interspire égale à dl. La spire L9 s'éloigne ensuite de la spire L8 pour contourner le trou h3 et son anneau conducteur r3 puis se prolonge dans la structure support SS16. A la sortie de la structure support SS16, la spire L9 contourne le trou h6 et son anneau conducteur r6, puis passe entre les trous h4, h5 et leur anneaux conducteurs pour atteindre la plage de connexion IP. La spire L8 suit également un chemin qui passe entre les trous h4, h5 et leurs anneaux conducteurs.

Les anneaux conducteurs r1, r3, r5, r6 sont reliés à la spire L9 et l'anneau conducteur r4 est relié à la spire L8 mais ne font pas partie des chemins conducteurs de ces spires. La zone centrale CA est délimitée par le contour de la spire L6 et la plage de connexion extérieure EP est comme précédemment située dans la zone centrale.

En pratique, le premier groupe de spires comprend généralement au moins 4 spires, pour couvrir les besoins des applications connues dans des conditions technologiques de mise en œuvre correspondant à l'état de l'art actuel, mais le premier perfectionnement n'est pas nécessairement limité à ce nombre minimal de spires du premier groupe.

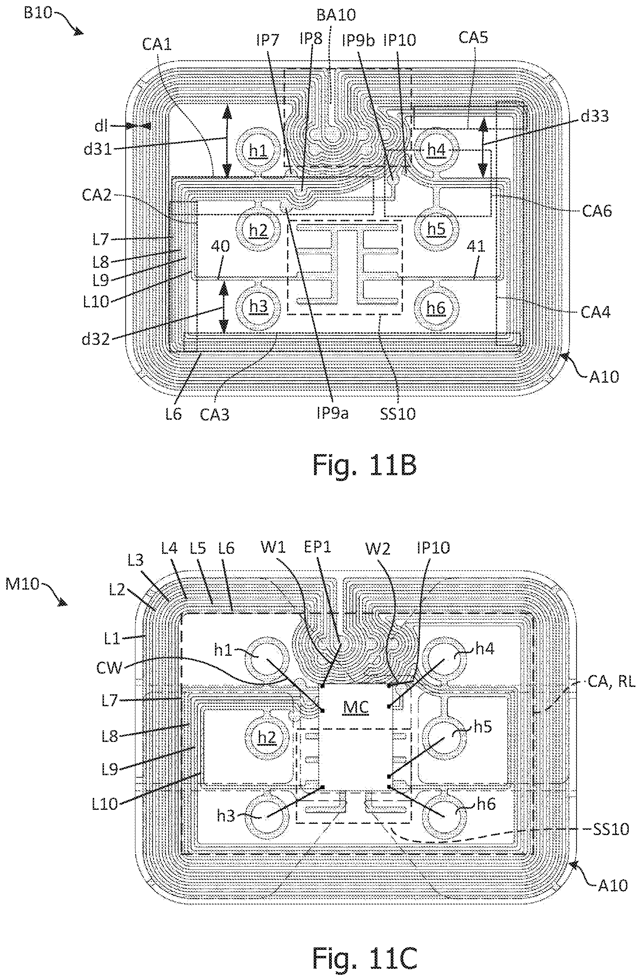

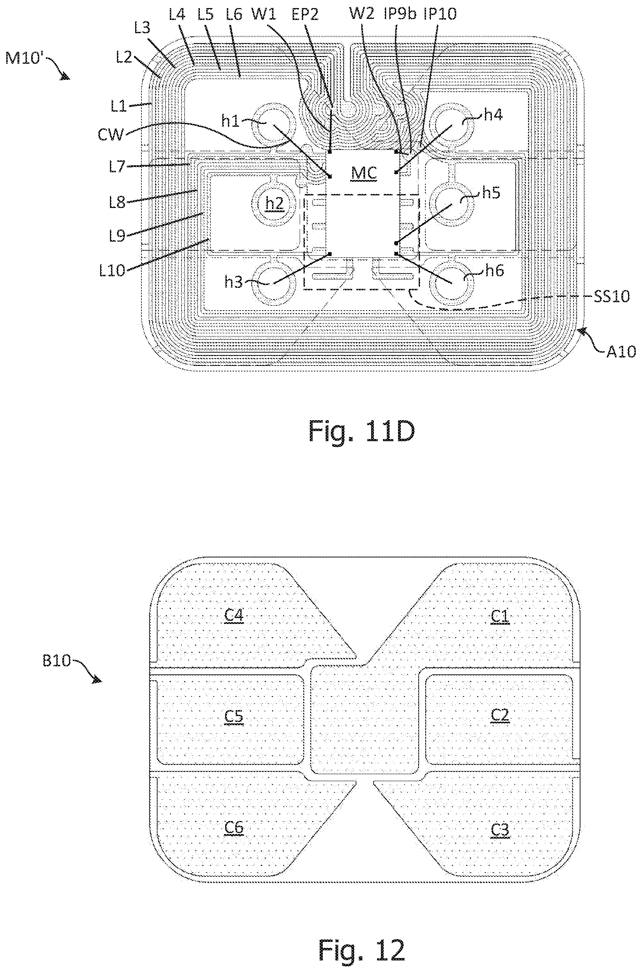

Les figures 11A, 11B montrent la face arrière d'une plaquette B10 mettant en œuvre le premier perfectionnement et un second perfectionnement. Les deux figures sont identiques mais la figure 11B montre des références d'éléments qui ne sont pas montrées sur la figure 11A, pour des raisons de lisibilité de la figure 11A. La figure 12 montre la face avant de la plaquette B10. Cette dernière comprend six plages de contact C1 à C6, par exemple des plages de contact ISO 7816. Ses dimensions sont par exemple de 11 x 8,32 mm.

En référence aux figures 11A, 11B, la face arrière de la plaquette B10 comprend 10 spires (N=10) divisées en un premier groupe de six spires L1 à L6 (E=6) et un second groupe de quatre spires L7à L10. Les spires du premier groupe de spires L1 à L6 présentent sensiblement la même distance interspire dl, le contour de la spire L6 délimitant une zone centrale CA à l'intérieur de laquelle sont formées une plage de connexion extérieure EP1 de la bobine d'antenne et une plage de connexion intérieure IP10 de la bobine d'antenne. La plage de connexion extérieure permet une connexion à la spire L1 et la plage de connexion intérieure IP10 permet une connexion à la spire L10. Comme précédemment, la bobine A10 comprend une zone de contournement BA10 dans laquelle chaque spire L1 à L10 contourne la plage de connexion extérieure EP1 par la zone centrale CA. La spire extérieure L1 suit la totalité du contour de la bobine d'antenne à l'exception d'une zone permettant le passage d'une piste conductrice T1 extérieure à la spire extérieure L1 et reliant la spire extérieure L1 à la plage de connexion EP1.

La plaquette B10 comprend également des trous h1 à h6 réalisés depuis sa face arrière et débouchant sur la face arrière des plages de contact C1 à C6 en face avant, sans les traverser, et des anneaux conducteurs r1 à r6 s'étendant autour des trous h1 à h6. Les trous forment une première rangée de trous h1 à h3 et une seconde rangée de trous h4 à h6 perpendiculaires ou sensiblement perpendiculaires à un axe longitudinal de la plaquette. Comme précédemment, dans certains modes de réalisation les trous peuvent ne pas être parfaitement alignés, leur axe d'alignement étant alors défini comme un axe qui passe au plus près du centre de chaque trou.

La plaquette B10 comprend également une structure support SS10, ici sensiblement en forme de « π » comprenant une première branche b1 et une deuxième branche b2 parallèles entre elles, une troisième branche b3 transversale reliant les branches b1, b2, trois branches b4 parallèles à la branche b3 et rattachées à la branche b1, et trois branches b5 parallèles à la branche b3 et rattachées à la branche b2.

Les spires du second groupe de spires L7-L10 comprennent des portions de spires qui se trouvent à une distance de la spire de rang précédent supérieure à la distance interspire dl du premier groupe de spires L1-L6. Plus particulièrement, comme montré sur la figure 11B, les spires L7-L10 comprennent un premier groupe CA1 de portions de spires distantes les unes des autres de la distance interspire dl, la portion de la spire L7 du groupe CA1 étant distante de la spire L6 d'une distance d31 qui est plusieurs fois supérieure à la distance dl. Après le groupe CA1, les spires L7-L10 comprennent un groupe CA2 de portions de spires perpendiculaires aux portions de spires du groupe CA1 et distantes les unes des autres de la distance interspire dl, la portion de la spire L7 du groupe CA2 étant distante de la spire L6 de la distance dl. Après le groupe CA2, les spires L7-L9 comprennent un groupe CA3 de portions de spires perpendiculaires aux portions de spires du groupe CA2 et distantes les unes des autres de la distance interspire dl, la portion de la spire L7 du groupe CA3 étant distante de la spire L6 de la distance dl. La spire L10 comprend ensuite une portion de spire 40 perpendiculaires aux portions de spires du groupe CA2, qui relie la portion de la spire L10 du groupe CA2 à une branche b4 de la structure support SS10 (Figs. 11A et 11B ensemble). Après le groupe CA3, les spires L7-L10 comprennent un groupe CA4 de portions de spires perpendiculaires aux portions de spires du groupe CA3 et distantes les unes des autres de la distance interspire dl.

La portion de la spire L7 du groupe CA4 est distante de la spire L6 de la distance dl. La portion 40 de la spire L10 est distante de la portion de la spire L9 du groupe CA3 d'une distance d32 qui est plusieurs fois supérieure à la distance dl. La spire L10 comprend également une portion de spire 41 perpendiculaires aux portions de spires du groupe CA4 et qui relie la portion de la spire L10 du groupe CA4 à une branche b5 de la structure support SS10. La portion 41 de la spire L10 est à la distance d32 de la portion de la spire L9 du groupe CA3 (Figs. 11A et 11B ensemble). Après le groupe CA4, les spires L7-L8 comprennent un groupe CA5 de portions de spires perpendiculaires aux portions de spires du groupe CA4 et distantes les unes des autres de la distance interspire dl, la portion de la spire L7 du groupe CA5 étant distante de la spire L6 de la distance dl. Les portions de spires L7-L8 du groupe CA5 rejoignent la zone de contournement BA10. Toujours après le groupe CA4, les spires L9-L10 comprennent un groupe CA6 de portions de spires perpendiculaires aux portions de spires du groupe CA4 et distantes les unes des autres de la distance interspire dl, la portion de la spire L9 du groupe CA6 étant distante de la portion de la spire L8 du groupe CA5 d'une distance d33 fois supérieure à la distance dl. La portion de la spire L10 du groupe CA6 se termine par la borne de connexion IP10.

Après la zone de contournement, les portions de spires du groupe CA1 des spires L7 à L10 suivent un chemin qui passe entre les trous h1 et h2 et leurs anneaux conducteurs r1, r2. Les portions de spires du groupe CA6 des spires L9 et L10 suivent un chemin qui passe entre les trous h4 et h5 et leurs anneaux conducteurs r4, r5.

Une partie de la structure support SS10 fait donc partie du chemin conducteur de la spire L10. Par contre, les anneaux conducteurs r1 à r6 sont seulement rattachés à des portions de spires et ne font pas partie des chemins conducteurs des spires.

Selon le second perfectionnement, la couche conductrice en face arrière est gravée de manière à former, dans la zone de contournement BA10, au moins une plage de connexion à une spire de rang supérieur à la spire L1 du premier groupe de spires L1-L6.

Plus particulièrement, la bobine d'antenne A10 comprend ici une plage EP2 de connexion à la spire L2, une plage EP3 de connexion à la spire L3, une plage EP3 de connexion à la spire L3, une plage EP4 de connexion à la spire L4, une plage EP5 de connexion à la spire L5, et une plage EP6 de connexion à la spire L6. Les plages de connexion EP2 à EP6 sont sensiblement circulaires et ont par exemple un diamètre de l'ordre de 300 micromètres pour une largeur de spire de l'ordre de 80 micromètres et une distance interspire de l'ordre de 80 micromètres. Les plages de connexion EP2 à EP6 sont formées dans la zone de contournement BA10 en maintenant la distance interspire dl entre les plages de connexion EP2 à EP6 et les spires adjacentes, de sorte que les portions de spires L1-L10 dans la zone de contournement présentent des « renflements » en arcs de cercles, de diamètres croissants en allant vers l'extérieur de la zone de contournement.

Optionnellement mais préférentiellement, la couche conductrice est également gravée de manière à former au moins une plage de connexion à une spire de rang inférieur à la spire L10 du second groupe de spires L7-L10. La bobine d'antenne A10 comprend ici deux plages IP9a, IP9b de connexion à la spire L9, une plage IP8 de connexion à la spire L8 et une plage IP7 de connexion à la spire L7. La plage IP9a est rattachée à la portion de la spire L9 du groupe CA1 et la plage IP9b est rattachée à la portion de la spire L9 du groupe CA6. Les plages IP7, IP8 sont rattachées aux portions des spires L7, L9 du groupe CA1.

Le second perfectionnement peut donc prévoir des plages de connexion supplémentaires aux spires du premier groupe, ou à la fois des plages de connexion supplémentaires aux spires du premier groupe et aux spires du second groupes, comme cela est représenté ici.

La figure 11C montre un module sans contact M10 réalisé à partir de la plaquette B10. Un microcircuit MC a été fixé sur la plaquette B10. Les premières bornes de connexion du microcircuit ont été reliées par des fils W1, W2 aux plages de connexion externe EP1 et interne IP10 de la bobine d'antenne A10. Des secondes bornes de connexion du microcircuit ont été reliées aux plages de contact C1, C3 à C6 en face avant (Fig. 12) par des fils CW passant dans les trous h1, h3 à h6. Le microcircuit MC repose sur une partie de la longueur et toute sa largeur sur la structure support SS10, et sur une autre partie de sa longueur et toute sa largeur sur des portions de spires L7 à L10 dans la zone de contournement. La zone centrale CA de la bobine d'antenne A10, délimitée ici par le contour de la spire L6, a été recouverte d'une couche de résine RL assurant la protection mécanique des fils W1, W2, CW.

La figure 11D montre un autre module sans contact M10' réalisé à partir de la plaquette B10. Un microcircuit MC a été fixé sur la plaquette B10. Les premières bornes de connexion du microcircuit ont été reliées par des fils W1, W2 à la plage de connexion EP2 de la spire L2, et à la plage de connexion IP9b de la spire L9. Ainsi, la spire L1 et la spire L10 ne font pas partie de la bobine d'antenne A10 telle que vue depuis les bornes de connexion du microcircuit.

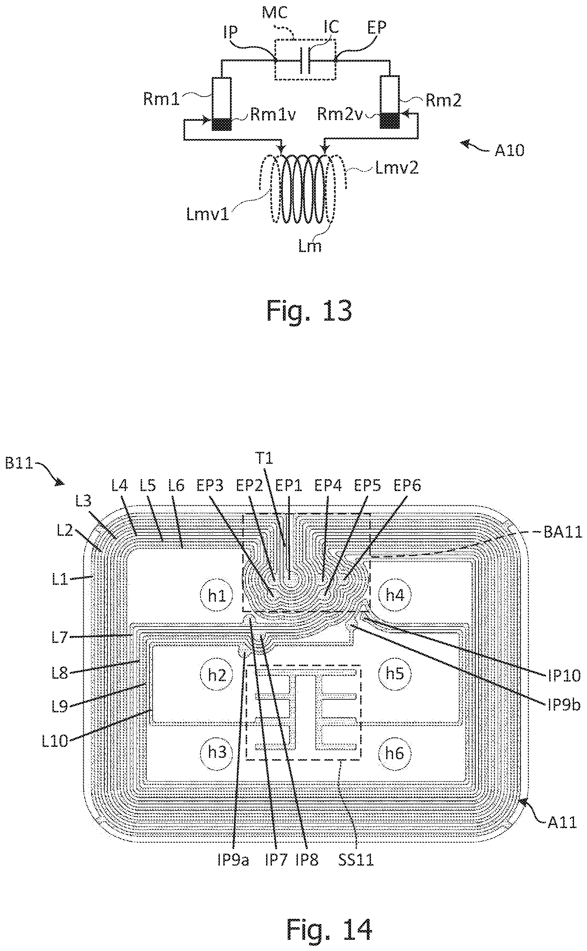

Comme illustré sur la figure 13, le choix de la borne de connexion à une spire du premier groupe L1-6 permet de faire varier une partie Lmv1 de l'inductance L de la bobine d'antenne vue par le microcircuit. Le choix de la borne de connexion à une spire du second groupe L7-L10 permet de faire varier une partie Lmv2 de l'inductance L de la bobine d'antenne vue par le microcircuit. A ces parties variables de l'inductance de la bobine d'antenne correspondent des parties variables Rm1, Rm2 de la résistance série de la bobine d'antenne telle que vue par le microcircuit.

La figure 14 montre une variante B11 de la plaquette B10 comprenant une bobine d'antenne A11 de même structure générale que la bobine d'antenne A10, avec une structure support SS11 identique à la structure support SS10 et une zone de contournement BA11 identique à la zone de contournement BA10. La plaquette B11 se distingue de la plaquette B10 en ce que la périphérie des trous h1 à h6 est dépourvue d'anneaux conducteurs. Par ailleurs, dans certains modes de réalisation, la première rangée de trous h1 à h3 et/ou la seconde rangée de trous h4 à h6 peuvent ne comprendre que deux trous au lieu de trois. En effet, selon les applications, certains trous peuvent ne pas être utilisés pour connecter le microcircuit à des plages de contact en face avant, comme on le voit par exemple sur la figure 11D où le trou h2 n'est pas utilisé.

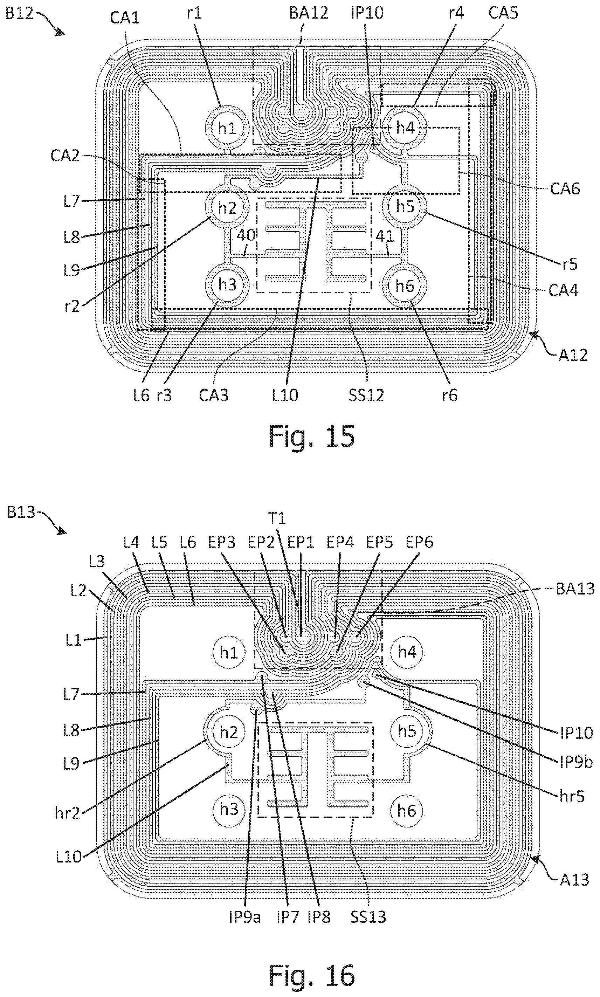

Diverses autres variantes de la plaquette B10 peuvent être prévues pour réaliser un micromodule sans contact. La figure 15 montre une variante B12 de la plaquette B10 comprenant une bobine d'antenne A12 qui ressemble à la bobine d'antenne A10, avec une structure support SS12 identique à la structure support SS10 et une zone de contournement BA12 identique à la zone de contournement BA10.La plaquette B12 se distingue de la plaquette B10 en ce que certains anneaux conducteurs, ici les anneaux conducteurs r2 et r5, font partie du chemin conducteur de la spire L10. Ainsi la portion de la spire L10 du groupe CA2 est reliée à l'anneau r2 qui est relié à structure support SS12 par l'intermédiaire de la portion 40. La portion 41 de la spire L10 est reliée à l'anneau conducteur r5 qui est lui-même relié à la portion de la piste L10 du groupe CA6, se terminant par la plage de connexion IP10.

La figure 16 montre une variante B13 de la plaquette B12 dans laquelle les anneaux conducteurs r1, r3, r4, r6 sont supprimés. L'anneau conducteur r2 est remplacé par un tronçon de piste hr2 en demi-cercle et l'anneau conducteur r5 est remplacé par un tronçon de piste hr5 en demi-cercle, les deux tronçons de pistes en demi-cercle faisant partie du chemin conducteur de la spire L10.

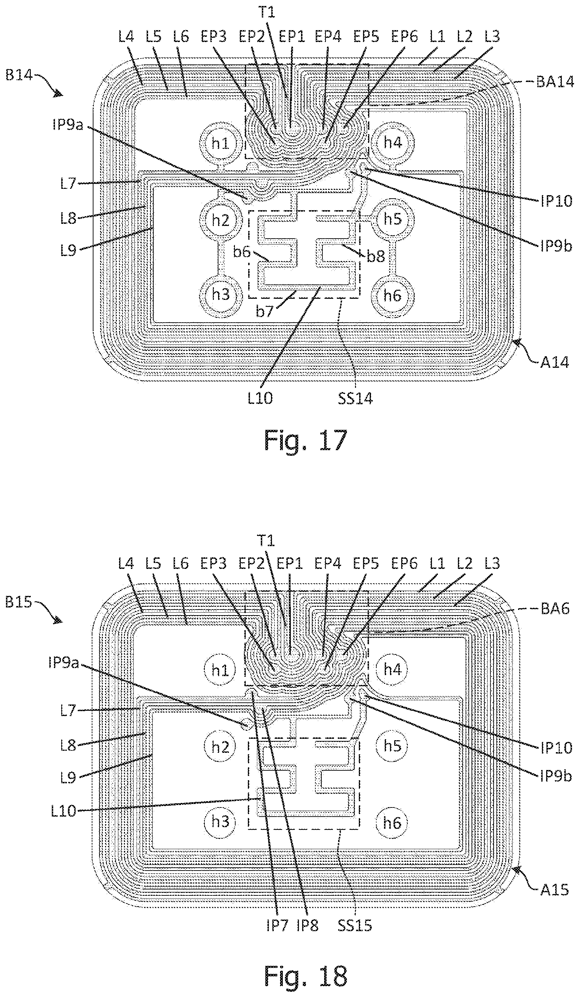

La figure 17 montre une variante B14 de la plaquette B12 dans laquelle la spire L10 forme une structure support SS14 comprenant deux tronçons de pistes conductrices b6, b8 en forme de créneaux et un tronçon droit b7 reliant les deux tronçons b6, b8. Le tronçon b6 est relié à la plage IP9a de la spire L9 et le tronçon b8 est relié à la plage IP10 de la spire L10. Les anneaux conducteurs s'étendant autour des trous h1 à h6 sont reliés aux spires de la bobine d'antenne mais ne font pas partie des chemins conducteurs formés par ces spires -ci. Dans une variante B15 de la plaquette B14 montrée sur la figure 18, ces anneaux conducteurs sont supprimés. Des modules sans contact peuvent, comme précédemment, être formés à partir de ces variantes B13, B14 et B15 de la plaquette B12.

Bien que les premier et second perfectionnements d'une structure de bobine d'antenne qui viennent d'être décrits présentent un intérêt particulier dans le cadre de la réalisation d'un module sans contact à deux modes de fonctionnement, de sorte que la présence des trous h1 à h6 a été prise en compte dans les exemples qui précèdent pour concevoir la structure de bobine d'antenne, il apparaitra clairement à l'homme de l'art que certaines caractéristiques de ces perfectionnements ne sont pas liées à la prévision de plages de contact sur la face avant du module.

La mise en œuvre d'un procédé de fabrication d'une bobine d'antenne selon le premier perfectionnement peut comprendre une étape de conception de la bobine d'antenne comprenant une étape préalable de détermination d'au moins une valeur cible L de l'inductance Lm de la bobine d'antenne et d'une valeur cible R de la résistance Rm de la bobine d'antenne telles que devant être vues depuis les premières bornes de connexion du microcircuit. Cette étape est suivie d'une étape de conception du premier groupe de spires et du second groupe de spires assistée par ordinateur, de manière que l'inductance Lm et la résistance Rm de la bobine d'antenne telles que vues par le microcircuit soient proches des valeurs L et R visées.

La mise en œuvre d'un procédé de fabrication d'une bobine d'antenne selon le second perfectionnement peut comprendre une étape de conception de la bobine d'antenne comprenant une étape préalable de détermination d'une pluralité de valeurs cibles L1, L2, L3... de l'inductance Lm de la bobine d'antenne et de valeurs cibles R1, R2, R2... de la résistance Rm de la bobine d'antenne telles que devant être vues par le microcircuit. Cette étape est suivie d'une étape de conception du premier groupe de spires et du second groupe de spires assistée par ordinateur, comprenant la prévision de plusieurs plages de connexion à des spires de rang différents du premier groupe de spires et/ou du second groupe de spires, de telle sorte que la bobine d'antenne présente plusieurs paires de plages de connexion. Chaque paire de plages de connexion comprend une plage de connexion à une spire du premier groupe de spires et une plage de connexion à une spire du second groupe de spires. La conception du premier groupe et du second groupe de spires et le choix de l'emplacement des bornes de connexion sont faits de manière à ce que l'inductance Lm et la résistance Rm de la bobine d'antenne telles que vues depuis chaque paire de plages de connexion de la bobine d'antenne soient proches de l'une des valeurs de la pluralité de valeurs cibles L1, L2, L3... de l'inductance Lm et de valeurs cibles R1, R2, R3... de la résistance Rm de la bobine d'antenne.

Pour mettre en œuvre ces étapes de conception, il peut être retenu de prévoir une largeur de spire et une distance interspire égales aux limites basses offertes par le procédé de gravure de la couche conductrice, cette largeur de spire étant généralement supérieure à l'épaisseur de peau du matériau conducteur utilisé, et de rechercher ensuite l'inductance la plus élevée entre les bornes de connexion de la spire extérieure et de la spire intérieure, afin d'obtenir une gamme d'inductances la plus large possible grâce aux plages de connexion intermédiaires.

Par ailleurs, il apparaîtra clairement à l'homme de l'art que le second perfectionnement est susceptible d'être mis en œuvre sans le premier perfectionnement, par exemple dans une structure d'antenne ne comprenant qu'un seul groupe de spires, en prévoyant une borne de connexion de chaque spire dans la zone de contournement. Il peut s'agir par exemple de la bobine d'antenne A14 de la figure 17 dépourvue des spires L7, L8 et L9, la spire L10 devenant alors la spire L7.

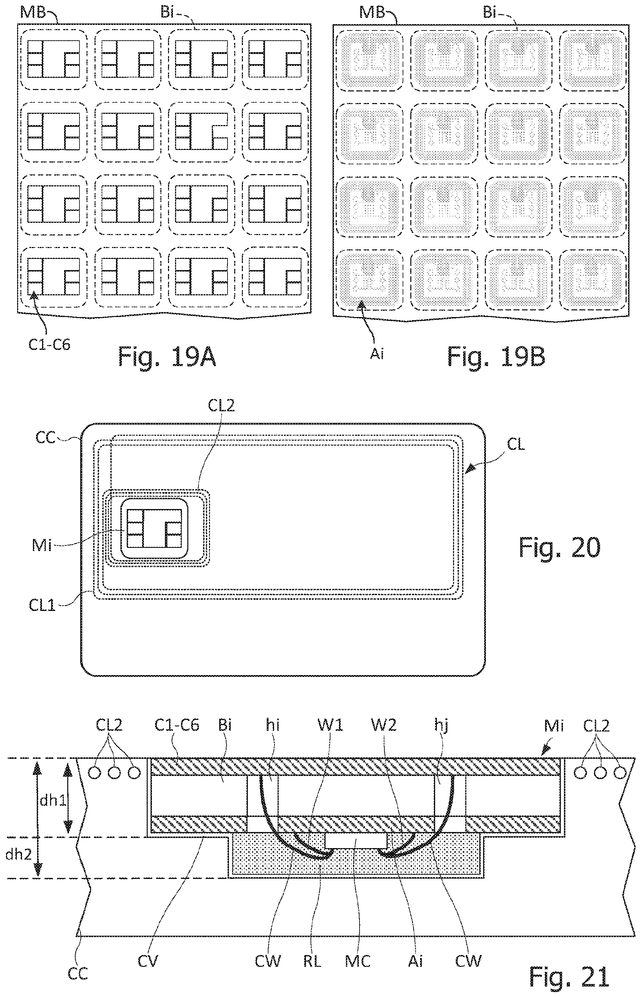

Selon un mode de réalisation illustrée sur la figure 19 (figures 19A, 19B), des plaquette Bi sont réalisées collectivement par gravure d'une plaque MB couverte sur chaque face d'une couche électriquement conductrice. La plaque peut être une plaque de circuit imprimé double face. Les figures 19A et 19B représentent les faces avant et arrière d'une partie de la plaque MB après gravure de ses deux faces. Sur la figure 19A, la plaque MB comprend plusieurs ensembles de plages de contact C1-C6. Les ensembles de plages de contact C1-C6 sont répartis sur la plaque MB en rangées et en colonnes. Sur la figure 19B, plusieurs bobines Ai sont formées sur la face arrière de la plaque MB, chaque bobine étant formée en regard d'un ensemble de plages de contact C1-C6.

A une étape suivante (non représentée), la plaque MB peut être percée à partir de la face arrière dans la zone centrale de chaque bobine Ai pour former dans la plaque des trous atteignant les plages de contact C1-C6. Un microcircuit peut être placé au centre de chaque bobine Ai, puis connecté à l'aide de fils aux plages de contacts C1-C6 et à la bobine Ai. La couche de résine RL décrite dans ce qui précède est ensuite déposée pour protéger chaque microcircuit avec ses fils de connexion sans recouvrir tout ou partie des spires des bobines d'antennes Ai. A cet effet, plusieurs techniques bien connues de l'homme du métier peuvent être utilisées :
- par injection et réticulation thermique d'une résine époxy au moyen de moules,
- au moyen d'une technique dite « dam & fill » faisant intervenir deux matières réticulables aux UV,
- par empotage, ou « potting », consistant à déposer une goutte de matière qui est activée thermiquement ou aux UV. Cette technique est la moins coûteuse mais est peu précise quant à l'épaisseur et la surface occupée par la couche de résine.

Dans une variante, la plaque MB est percée pour former les trous h1-h6 avant d'être recouverte des couches conductrices avant et arrière. Dans un exemple de réalisation, un substrat de base en époxy-verre comprenant une couche de cuivre sur sa face arrière se voit ajouter une couche de cuivre sur sa face avant avec interposition d'une couche d'adhésif. Les deux faces recouvertes de cuivre sont ensuite gravées puis percées pour former les deux rangées de trous h1-h6.

La figure 20 montre une carte CC comprenant un module sans contact Mi selon l'un des deux, ou selon les deux perfectionnements qui viennent d'être décrits. La figure 21 est une vue en coupe de la carte CC. La carte CC comprend une cavité CV recevant le module Mi, une bobine d'antenne CL qui est incluse dans le corps de la carte et comprend une ou plusieurs grandes spires CL1 et une ou plusieurs petites spires CL2. Les petites spires CL2 entourent le module Mi et assurent un couplage inductif entre la bobine d'antenne Ai du module Mi et la bobine d'antenne CL. Les plages de contact C1-C6 et la bobine d'antenne Ai du module Mi sont représentées schématiquement par une couche hachurée sur la figure 21. La figure 21 montre les fils CW du module Mi traversant des trous hi, hj de l'ensemble de trous h1-h6, et les fils W1, W2 reliant les premières bornes de connexion du microcircuit MC à des plages de connexion de la bobine d'antenne Ai, ainsi que la couche de résine RL qui encapsule le microcircuit et les fils W1, W2, CW.

La cavité CV présente à sa périphérie une première profondeur dh1 lui permettant de recevoir la périphérie du module sans contact Mi. La profondeur dh1 est de préférence sensiblement inférieure à la somme de l'épaisseur de la plaquette Bi à partir de laquelle le module sans contact Mi est réalisé, de l'épaisseur d'un adhésif permettant de fixer le module Mi dans la cavité, de l'épaisseur de la couche conductrice formant la bobine d'antenne Ai et de l'épaisseur de la couche conductrice formant les plages de contact C1-C6 en face avant, et est calculée de manière que les plages de contact C1-C6 dépassent sensiblement de la surface de la carte (typiquement de 10 à 50 micromètres).

La cavité CV présente également une région centrale dont la profondeur dh2 doit être sensiblement supérieure à la somme de la première profondeur dh1 et de l'épaisseur de la couche de résine RL, pour qu'il subsiste un espace vide, par exemple de 20 micromètres, permettant d'absorber les variations de distance entre le fond de la cavité et la face arrière du module lorsque la carte est soumise à une flexion.

Comme rappelé plus haut, la surface de la région centrale de la cavité présentant la profondeur dh2 doit de préférence être la plus faible possible devant la surface totale de la cavité, afin de ne pas fragiliser la carte. De ce fait, il est souhaitable que la surface du module recouverte par la couche de résine RL soit minimale. Cette surface minimale correspond sensiblement à la région centrale de la bobine dans laquelle s'étendent les fils W1, W2, CW, à laquelle peut être ajoutée une bordure de sécurité.

## Revendications

1. Procédé de fabrication d'un module sans contact (M3-M6, M10, M10'), comprenant des étapes consistant à :
- déposer une première couche électriquement conductrice sur une première face d'une plaquette (B3-B6, B10-B16),
former une bobine d'antenne (A3-A6, A10-A16) par gravure de la première couche, la bobine d'antenne comportant des spires (L1-L8, L1-L9, L1-L10) de rangs croissants en allant de l'extérieur vers l'intérieur de la bobine d'antenne, dont une spire extérieure (L1) de rang 1 et une spire intérieure (L8, L9, L10) de rang N, la spire intérieure étant reliée à une plage de connexion intérieure (IP, IP10) et la spire extérieure reliée à une plage de connexion extérieure (EP, EP1),
- fixer un microcircuit (MC) sur la première face de la plaquette, dans une zone centrale (CA) de la bobine d'antenne délimitée par une spire de la bobine d'antenne, et
- relier des premières bornes de connexion du microcircuit (MC) à des plages de connexion de la bobine d'antenne, par l'intermédiaire de fils (W1, W2), procédé dans lequel la première couche est gravée de manière que les plages de connexion extérieure (EP, EP1) et intérieure (IP, IP10) de la bobine d'antenne soient formées dans la zone centrale (CA) de la bobine d'antenne, la bobine d'antenne comprenant une zone de contournement (BA3-BA6, BA10-BA16) dans laquelle chaque spire contourne la plage de connexion extérieure par la zone centrale,
procédé **caractérisé en ce que** la première couche est gravée de manière que :
- la bobine d'antenne comprend un premier groupe de spires (L1-L5, L1-L6) de rangs 1 à E, présentant sensiblement la même distance interspire (dl), la spire de rang E étant la spire intérieure du premier groupe de spires, E étant au moins égal à 4,
- la zone centrale (CA) est délimitée par le contour de la spire intérieure (L5, L6) du premier groupe de spires, et
- la bobine d'antenne comprend un second groupe d'au moins deux spires (L7-L8, L6-L9, L7-L9, L7-L10) de rangs E+1 à N, qui s'étend à l'intérieur de la zone centrale, chaque spire du second groupe de spires comprenant des portions de spires (10-21) qui se trouvent à des distances (d10-d21) variables de la spire de rang précédent, lesdites distances étant comprises entre ladite distance interspire (dl) et plusieurs fois la distance interspire.

2. Procédé selon la revendication 1, comprenant des étapes consistant à :
- déposer une seconde couche électriquement conductrice sur une seconde face de la plaquette,
- former dans la seconde couche des plages de contact (C1-C6), et
- former deux rangées (h1-h3, h4-h6) de deux ou trois trous chacune dans la plaquette, jusqu'à atteindre les plages de contact de la seconde couche, les rangées de trous étant sensiblement perpendiculaires à un axe longitudinal du module,
procédé dans lequel la première couche est gravée de manière que tout ou partie des spires du second groupe suivent un chemin qui passe entre au moins deux trous d'au moins une rangée de trous.

3. Procédé selon l'une des revendications 1 et 2, dans lequel le microcircuit (MC) est supporté en tout ou en partie par au moins la spire intérieure (L8, L9, L10) de la bobine d'antenne et peut également être supporté par au moins une portion de spire du premier groupe de spires s'étendant dans la zone de contournement.

4. Procédé selon l'une des revendications 1 à 3, dans lequel la couche conductrice est gravée de manière à comporter une structure support (SS3-SS6, SS10-SS16) pour supporter tout ou partie du microcircuit (MC), la structure support étant reliée électriquement à la spire intérieure de la bobine d'antenne.

5. Procédé selon la revendication 4, dans lequel au moins une partie de la structure support (SS3-SS6, SS10-SS16) forme un chemin conducteur faisant partie de la spire intérieure de la bobine d'antenne.

6. Procédé selon l'une des revendications 1 à 5, dans lequel la couche conductrice est gravée de manière à former, dans la zone de contournement, au moins une plage de connexion (EP2-EP6) à une spire de rang supérieur à 1 du premier groupe de spires.

7. Procédé selon la revendication 6, comprenant une étape consistant à relier une première des premières bornes de connexion du microcircuit (MC) à la plage de connexion (EP2-EP6) d'une spire de rang supérieur à 1 du premier groupe de spires.

8. Procédé selon l'une des revendications 1 à 6, dans lequel la couche conductrice est gravée de manière à former, dans la zone centrale, au moins une plage de connexion (IP7-IP9) à une spire de rang inférieur à N du second groupe de spires.

9. Procédé selon la revendication 8, comprenant une étape consistant à relier une seconde des premières bornes de connexion du microcircuit à la plage de connexion (IP7-IP9) d'une spire de rang inférieur à N du second groupe de spires.

10. Procédé selon l'une des revendications 1 à 9, comprenant une étape de dépôt d'une couche de protection (RL) électriquement isolante sur le microcircuit (MC) et les fils de connexion (CW, W1, W1).

11. Procédé selon l'une des revendications 1 à 10, dans lequel la plaquette appartient à une plaque (MB) dans laquelle sont formés collectivement plusieurs modules sans contact, le procédé comprenant une étape de découpe de la plaque pour individualiser les modules, effectuée après connexion de chaque microcircuit.

12. Procédé de fabrication d'un module sans contact selon l'une des revendications 1 à 11, comprenant une étape de conception de la bobine d'antenne comprenant :
- une étape de détermination d'au moins une valeur cible de l'inductance (Lm) et d'une valeur cible de la résistance (Rm) de la bobine d'antenne telles que devant être vues depuis les premières bornes de connexion du microcircuit,
- une étape de conception du premier groupe de spires et du second groupe de spires de manière que l'inductance (Lm) et la résistance (Rm) de la bobine d'antenne telles que vues depuis des plages de connexion de la bobine d'antenne soient proches des valeurs cibles visées.

13. Procédé de fabrication d'un module sans contact selon l'une des revendications 1 à 11, comprenant une étape de conception de la bobine d'antenne comprenant :
- une étape de détermination d'une pluralité de valeurs cibles de l'inductance (Lm) et de valeurs cibles de la résistance (Rm) de la bobine d'antenne telles que devant être vues depuis les premières bornes de connexion du microcircuit,
- une étape de conception du premier groupe de spires et du second groupe de spires, comprenant la prévision de plusieurs plages de connexion (EP, EP1-EP6, IP, IP7-IP10) à des spires de rangs différents du premier groupe de spires et/ou du second groupe de spires, de telle sorte que la bobine d'antenne présente plusieurs paires de plages de connexion, chaque paire de plages de connexion comprenant une plage de connexion à une spire du premier groupe de spires et une plage de connexion à une spire du second groupe de spires, procédé dans lequel la conception du premier groupe et du second groupe de spires et le choix de l'emplacement des bornes de connexion sont faits de manière à ce que l'inductance (Lm) et la résistance (Rm) de la bobine d'antenne telles que vues depuis chaque paire de plages de connexion de la bobine d'antenne soient proches de l'une des valeurs de la pluralité de valeurs cibles de l'inductance (Lm) et de valeurs cibles de la résistance (Rm) de la bobine d'antenne.

14. Procédé de fabrication d'une carte à microcircuit comprenant des étapes consistant à :
exécuter le procédé selon l'une des revendications 1 à 13, pour obtenir un module sans contact (M3-M6, M10, M10'),
former une bobine d'antenne (CL) dans une carte (CC), et
implanter le module dans la carte, la bobine d'antenne de la carte présentant au moins une spire (CL2) proche de la bobine d'antenne (A3-A6, A10-A16) du microcircuit pour établir un couplage inductif entre les deux bobines d'antenne.

15. Module sans contact (M3-M6, M10, M10'), comprenant
- une plaquette (B3-B6, B10-B16) recouverte sur une première face d'une première couche électriquement conductrice dans laquelle est formée une bobine d'antenne (A3-A6, A10-A16), la bobine d'antenne comportant des spires (L1-L8, L1-L9, L1-L10) de rangs croissants en allant de l'extérieur vers l'intérieur de la bobine d'antenne, dont une spire extérieure (L1) de rang 1 et une spire intérieure (L8, L9, L10) de rang N, la spire intérieure étant reliée à une plage de connexion intérieure (IP, IP10) et la spire extérieure reliée à une plage de connexion extérieure (EP, EP1),
- un microcircuit fixé (MC) sur la première face de la plaquette, dans une zone centrale (CA) de la bobine d'antenne délimitée par une spire de la bobine d'antenne, et comportant des premières bornes de connexion reliées à des plages de connexion de la bobine d'antenne par l'intermédiaire de fils (W1, W2),
dans lequel les plages de connexion extérieure (EP, EP1) et intérieure (IP, IP10) de la bobine d'antenne sont formées dans la zone centrale (CA) de la bobine d'antenne, la bobine d'antenne comprenant une zone de contournement (BA3-BA6, BA10-BA16) dans laquelle chaque spire contourne la plage de connexion extérieure par la zone centrale,
**caractérisé en ce que** :
- la bobine d'antenne comprend un premier groupe de spires (L1-L6, L1-L7) de rangs 1 à E présentant sensiblement la même distance interspire (dl), la spire de rang E étant la spire intérieure du premier groupe de spires, E étant au moins égal à 4,
- la zone centrale (CA) est délimitée par le contour de la spire intérieure (L5, L6) du premier groupe de spires,
- la bobine d'antenne comprend un second groupe d'au moins deux spires (L7-L8, L6-L9, L7-L9, L7-L10) de rangs E+1 à N, qui s'étend à l'intérieur de la zone centrale, chaque spire du second groupe de spires comprenant des portions de spires (10-21) qui se trouvent à des distances (d10-d21) variables de la spire de rang précédent, lesdites distances étant comprises entre ladite distance interspire (dl) et plusieurs fois la distance interspire.

16. Module selon la revendication 15, dans lequel la plaquette comprend des plages de contact (C1-C6) sur une seconde face de la plaquette, deux rangées (h1-h3, h4-h6) de deux ou trois trous chacune pratiquées dans la plaquette, atteignant les plages de contact sur la seconde face, les rangées de trous étant sensiblement perpendiculaires à un axe longitudinal du module, et dans lequel tout ou partie des spires du second groupe de spires suivent un chemin qui passe entre au moins deux trous d'au moins une rangée de trous.

17. Module selon l'une des revendications 15 et 16, dans lequel le microcircuit (MC) est supporté en tout ou en partie par au moins la spire intérieure (L8, L9, L10) de la bobine d'antenne et peut être également supporté par au moins une portion de spire du premier groupe de spires s'étendant dans la zone de contournement.

18. Module selon l'une des revendications 15 à 17, dans lequel la couche conductrice comporte une structure support (SS3-SS6, SS10-SS16) pour supporter tout ou partie du microcircuit, la structure support étant reliée électriquement à la spire intérieure de la bobine d'antenne.

19. Module selon la revendication 18, dans lequel au moins une partie de la structure support (SS3-SS6, SS10-SS16) forme un chemin conducteur faisant partie de la spire intérieure de la bobine d'antenne.

20. Module selon l'une des revendications 15 à 19, dans lequel la bobine d'antenne comprend, dans la zone de contournement, au moins une plage de connexion (EP2-EP6) à une spire de rang supérieur à 1 du premier groupe de spires.

21. Module selon la revendication 20, dans lequel une première des premières bornes de connexion du microcircuit (MC) est reliée à la plage de connexion (EP2-EP6) d'une spire de rang supérieur à 1 du premier groupe de spires.

22. Module selon l'une des revendications 15 à 21, dans lequel la bobine d'antenne comprend, dans la zone centrale, au moins une plage de connexion (IP7-IP8, IP9a,IP9b) à une spire de rang inférieur à N du second groupe de spires, à laquelle est connectée ou peut être connectée une seconde des premières bornes de connexion du microcircuit.

23. Carte à microcircuit (CC) comprenant une bobine d'antenne (CL) et un module sans contact (M3-M6, M10, M10') selon l'une des revendications 15 à 22, la bobine d'antenne de la carte présentant au moins une spire (CL2) proche de la bobine d'antenne (A3-A6, A10-A16) du module, pour établir un couplage inductif entre les deux bobines d'antenne.

## Patentansprüche

1. Verfahren zum Herstellen eines kontaktlosen Moduls (M3-M6, M10, M10'), umfassend die Schritte bestehend aus:
- Aufbringen einer ersten elektrisch leitfähigen Schicht auf einer ersten Seite eines Wafers (B3-B6, B10-B16),
Bilden einer Antennenspule (A3-A6, A10-A16) durch Ätzen der ersten Schicht, wobei die Antennenspule Windungen (L1-L8, L1-L9, L1-L10) mit von außen nach innen der Antennenspule zunehmendem Rang umfasst, darunter eine äußere Windung (L1) mit Rang 1 und eine innere Windung (L8, L9, L10) mit Rang N, wobei die innere Windung an einer inneren Verbindungsfläche (IP, IP10) und die äußere Windung an einer äußeren Verbindungsfläche (EP, EP1) angeschlossen ist,
- Befestigen einer Mikroschaltung (MC) auf der ersten Seite des Wafers in einer zentralen Zone (CA) der Antennenspule, die durch eine Windung der Antennenspule begrenzt ist, und
- Anschließen erster Verbindungsklemmen der Mikroschaltung (MC) an Verbindungsflächen der Antennenspule über Drähte (W1, W2), wobei die erste Schicht so geätzt wird, dass die äußeren Verbindungsflächen (EP, EP1) und die inneren Verbindungsflächen (IP, IP10) der Antennenspule im zentralen Bereich (CA) der Antennenspule gebildet werden, wobei die Antennenspule einen Umgehungsbereich (BA3-BA6, BA10-BA16) umfasst, in der jede Windung die äußere Verbindungsfläche über den zentralen Bereich umgeht,
Verfahren, **dadurch gekennzeichnet, dass** die erste Schicht so geätzt wird, dass:
- die Antennenspule eine erste Gruppe von Windungen (L1-L5, L1-L6) mit den Rängen 1 bis E umfasst, die im Wesentlichen den gleichen Windungsabstand (dl) aufweisen, wobei die Windung mit dem Rang E die innere Windung der ersten Windungsgruppe ist, wobei E mindestens gleich 4 ist,
- der zentrale Bereich (CA) durch den Umriss der inneren Windung (L5, L6) der ersten Windungsgruppe begrenzt wird, und
- die Antennenspule eine zweite Gruppe von mindestens zwei Windungen (L7-L8, L6-L9, L7-L9, L7-L10) mit den Rängen E+1 bis N umfasst, die sich innerhalb des zentralen Bereichs erstreckt, wobei jede Windung der zweiten Windungsgruppe Windungsabschnitte (10-21) umfasst, die in variablen Abständen (d10-d21) von der Windung mit dem vorhergehenden Rang angeordnet sind, wobei die Abstände zwischen dem Windungsabstand (dl) und einem Mehrfachen des Windungsabstands liegen.

2. Verfahren nach Anspruch 1, umfassend die Schritte bestehend aus:
- Aufbringen einer zweiten elektrisch leitfähigen Schicht auf einer zweiten Seite des Wafers,
- Bilden von Kontaktflächen in der zweiten Schicht (C1-C6), und
- Bilden von zwei Reihen (h1-h3, h4-h6) mit jeweils zwei oder drei Löchern im Wafer, bis die Kontaktflächen der zweiten Schicht erreicht sind, wobei die Lochreihen im Wesentlichen senkrecht zu einer Längsachse des Moduls verlaufen,
Verfahren, wobei die erste Schicht so geätzt wird, dass alle oder ein Teil der Windungen der zweiten Gruppe einem Pfad folgen, der zwischen mindestens zwei Löchern mindestens einer Lochreihe verläuft.

3. Verfahren nach einem der Ansprüche 1 und 2, wobei die Mikroschaltung (MC) ganz oder teilweise von mindestens der inneren Windung (L8, L9, L10) der Antennenspule getragen wird und außerdem von mindestens einem Teil der Windungen der ersten Windungsgruppe getragen werden kann, die sich im Umgehungsbereich erstrecken.

4. Verfahren nach einem der Ansprüche 1 bis 3, wobei die leitfähige Schicht so geätzt wird, dass sie eine Trägerstruktur (SS3-SS6, SS10-SS16) aufweist, um die Mikroschaltung (MC) ganz oder teilweise zu tragen, wobei die Trägerstruktur elektrisch an die innere Windung der Antennenspule angeschlossen ist.

5. Verfahren nach Anspruch 4, wobei mindestens ein Abschnitt der Trägerstruktur (SS3-SS6, SS10-SS16) einen leitenden Pfad bildet, der Teil der inneren Windung der Antennenspule ist.

6. Verfahren nach einem der Ansprüche 1 bis 5, wobei die leitfähige Schicht so geätzt wird, dass sie im Umgehungsbereich mindestens eine Verbindungsfläche (EP2-EP6) zu einer Windung mit einem höheren Rang als 1 der ersten Windungsgruppe bildet.

7. Verfahren nach Anspruch 6, umfassend einen Schritt zum Anschließen eines ersten der ersten Verbindungsklemmen der Mikroschaltung (MC) an die Verbindungsfläche (EP2-EP6) einer Windung mit einem Rang höher als 1 der ersten Windungsgruppe.

8. Verfahren nach einem der Ansprüche 1 bis 6, wobei die leitfähige Schicht so geätzt wird, dass sie in dem zentralen Bereich mindestens eine Verbindungsfläche (IP7-IP9) zu einer Windung mit einem niedrigeren Rang als N der zweiten Windungsgruppe bildet.

9. Verfahren nach Anspruch 8, umfassend einen Schritt zum Anschließen einer zweiten der ersten Verbindungsklemmen der Mikroschaltung an die Verbindungsfläche (IP7-IP9) einer Windung mit einem Rang niedriger als N der zweiten Windungsgruppe.

10. Verfahren nach einem der Ansprüche 1 bis 9, umfassend einen Schritt zum Aufbringen einer elektrisch isolierenden Schutzschicht (RL) auf die Mikroschaltung (MC) und die Anschlussdrähte (CW, W1, W1).

11. Verfahren nach einem der Ansprüche 1 bis 10, wobei der Wafer zu einer Platte (MB) gehört, auf der mehrere kontaktlose Module gemeinsam gebildet sind, wobei das Verfahren einen Schritt zum Schneiden der Platte zum Vereinzeln der Module umfasst, der nach der Verbindung jeder Mikroschaltung ausgeführt wird.

12. Verfahren zum Herstellen eines kontaktlosen Moduls nach einem der Ansprüche 1 bis 11, umfassend einen Schritt zum Entwerfen der Antennenspule, umfassend:
- einen Schritt zum Bestimmen mindestens eines Zielwerts der Induktivität (Lm) und eines Zielwerts des Widerstands (Rm) der Antennenspule, wie sie von den ersten Verbindungsklemmen der Mikroschaltung aus gesehen werden müssen,
- einen Schritt zum Entwerfen der ersten Windungsgruppe und der zweiten Windungsgruppe, sodass die Induktivität (Lm) und der Widerstand (Rm) der Antennenspule, von den Verbindungsflächen der Antennenspule aus gesehen, nahe an den angestrebten Zielwerten liegen.

13. Verfahren zum Herstellen eines kontaktlosen Moduls nach einem der Ansprüche 1 bis 11, umfassend einen Schritt zum Entwerfen der Antennenspule, umfassend:
- einen Schritt zum Bestimmen einer Vielzahl von Zielwerten der Induktivität (Lm) und von Zielwerten des Widerstands (Rm) der Antennenspule, wie sie von den ersten Verbindungsklemmen der Mikroschaltung aus gesehen werden müssen,
- einen Schritt zum Entwerfen der ersten Windungsgruppe und der zweiten Windungsgruppe, umfassend das Vorsehen mehrerer Verbindungsflächen (EP, EP1-EP6, IP, IP7-IP10) für Windungen unterschiedlichen Ranges der ersten Windungsgruppe und/oder der zweiten Windungsgruppe, sodass die Antennenspule mehrere Verbindungsflächenpaare aufweist, wobei jedes Verbindungsflächenpaar eine Verbindungsfläche zu einer Windung der ersten Windungsgruppe und eine Verbindungsfläche zu einer Windung der zweiten Windungsgruppe umfasst, wobei das Entwerfen der ersten und der zweiten Windungsgruppe und die Wahl der Position der Verbindungsklemmen so erfolgen, dass die Induktivität (Lm) und der Widerstand (Rm) der Antennenspule, von jedem Verbindungsflächenpaar der Antennenspule aus gesehen, nahe an einem der Werte aus der Vielzahl von Zielwerten der Induktivität (Lm) und Zielwerten des Widerstands (Rm) der Antennenspule liegen.

14. Verfahren zum Herstellen einer Mikroschaltungskarte, umfassend die Schritte bestehend aus:
Ausführen des Verfahrens nach einem der Ansprüche 1 bis 13, um ein kontaktloses Moduls (M3-M6, M10, M10') zu erhalten,
Bilden einer Antennenspule (CL) in einer Karte (CC) und
Einsetzen des Moduls in die Karte, wobei die Antennenspule der Karte mindestens eine Windung (CL2) in der Nähe der Antennenspule (A3-A6, A10-A16) der Mikroschaltung aufweist, um eine induktive Kopplung zwischen den beiden Antennenspulen herzustellen.

15. Kontaktloses Moduls (M3-M6, M10, M10'), umfassend
- einen Wafer (B3-B6, B10-B16), der auf einer ersten Seite mit einer ersten elektrisch leitfähigen Schicht bedeckt ist, in der eine Antennenspule (A3-A6, A10-A16) gebildet ist, wobei die Antennenspule Windungen (L1-L8, L1-L9, L1-L10) mit von außen nach innen der Antennenspule zunehmendem Rang umfasst, darunter eine äußere Windung (L1) mit Rang 1 und eine innere Windung (L8, L9, L10) mit Rang N, wobei die innere Windung an einer inneren Verbindungsfläche (IP, IP10) und die äußere Windung an einer äußeren Verbindungsfläche (EP, EP1) angeschlossen ist,
- eine Mikroschaltung (MC), die auf der ersten Seite des Wafers in einem zentralen Bereich (CA) der Antennenspule befestigt ist, der durch eine Windung der Antennenspule begrenzt wird, und erste Verbindungsklemmen aufweist, die über Drähte (W1, W2) an Verbindungsflächen der Antennenspule angeschlossen sind,
wobei die äußeren Verbindungsflächen (EP, EP1) und die inneren Verbindungsflächen (IP, IP10) der Antennenspule im zentralen Bereich (CA) der Antennenspule gebildet sind, wobei die Antennenspule einen Umgehungsbereich (BA3-BA6, BA10-BA16) umfasst, in dem jede Windung die äußere Verbindungsfläche über den zentralen Bereich umgeht,
**dadurch gekennzeichnet, dass**:
- die Antennenspule eine erste Gruppe von Windungen (L1-L6, L1-L7) mit den Rängen 1 bis E umfasst, die im Wesentlichen den gleichen Windungsabstand (dl) aufweisen, wobei die Windung mit dem Rang E die innere Windung der ersten Windungsgruppe ist, wobei E mindestens gleich 4 ist,
- der zentrale Bereich (CA) durch den Umriss der inneren Windung (L5, L6) der ersten Windungsgruppe begrenzt wird,
- die Antennenspule eine zweite Gruppe von mindestens zwei Windungen (L7-L8, L6-L9, L7-L9, L7-L10) mit den Rängen E+1 bis N umfasst, die sich innerhalb des zentralen Bereichs erstreckt, wobei jede Windung der zweiten Windungsgruppe Windungsabschnitte (10-21) umfasst, die in variablen Abständen (d10-d21) von der Windung mit dem vorhergehenden Rang angeordnet sind, wobei die Abstände zwischen dem Windungsabstand (dl) und einem Mehrfachen des Windungsabstands liegen.

16. Modul nach Anspruch 15, wobei der Wafer Kontaktflächen (C1-C6) auf einer zweiten Seite des Wafers und zwei Reihen (h1-h3, h4-h6) aus jeweils zwei oder drei Löchern im Wafer umfasst, die zu den Kontaktflächen auf der zweiten Seite reichen, wobei die Lochreihen im Wesentlichen senkrecht zu einer Längsachse des Moduls verlaufen, und wobei alle oder ein Teil der Windungen der zweiten Windungsgruppe einem Pfad folgen, der zwischen mindestens zwei Löchern mindestens einer Lochreihe verläuft.

17. Modul nach einem der Ansprüche 15 und 16, wobei die Mikroschaltung (MC) ganz oder teilweise von mindestens der inneren Windung (L8, L9, L10) der Antennenspule getragen wird und außerdem von mindestens einem Teil der Windungen der ersten Windungsgruppe getragen werden kann, die sich im Umgehungsbereich erstrecken.

18. Modul nach einem der Ansprüche 15 bis 17, wobei die leitfähige Schicht eine Trägerstruktur (SS3-SS6, SS10-SS16) zum Tragen der gesamten oder eines Teils der Mikroschaltung aufweist, wobei die Trägerstruktur elektrisch an die innere Windung der Antennenspule angeschlossen ist.

19. Modul nach Anspruch 18, wobei mindestens ein Abschnitt der Trägerstruktur (SS3-SS6, SS10-SS16) einen leitenden Pfad bildet, der Teil der inneren Windung der Antennenspule ist.

20. Modul nach einem der Ansprüche 15 bis 19, wobei die Antennenspule im Umgehungsbereich mindestens eine Verbindungsfläche (EP2-EP6) zu einer Windung mit einem Rang höher als 1 der ersten Windungsgruppe umfasst.

21. Modul nach Anspruch 20, wobei eine erste der ersten Verbindungsklemmen der Mikroschaltung (MC) an die Verbindungsfläche (EP2-EP6) einer Windung mit einem Rang höher als 1 der ersten Windungsgruppe angeschlossen ist.

22. Modul nach einem der Ansprüche 15 bis 21, wobei die Antennenspule im zentralen Bereich mindestens eine Verbindungsfläche (IP7-IP8, IP9a, IP9b) zu einer Windung mit einem niedrigeren Rang als N der zweiten Windungsgruppe umfasst, mit der eine zweite der ersten Verbindungsklemmen der Mikroschaltung verbunden ist oder verbunden werden kann.

23. Mikroschaltungskarte (CC), umfassend eine Antennenspule (CL) und ein kontaktloses Modul (M3-M6, M10, M10') nach einem der Ansprüche 15 bis 22, wobei die Antennenspule der Karte mindestens eine Windung (CL2) in der Nähe der Antennenspule (A3-A6, A10-A16) des Moduls aufweist, um eine induktive Kopplung zwischen den beiden Antennenspulen herzustellen.

## Claims

1. A method for manufacturing a contactless module (M3-M6, M10, M10'), comprising steps that consist in:
- depositing a first electrically conductive layer on a first face of a wafer (B3-B6, B10-B16),
forming an antenna coil (A3-A6, A10-A16) by etching the first layer, the antenna coil including turns (L1-L8, L1-L9, L1-L10) of increasing rank from the outside toward the inside of the antenna coil, including an outer turn (L1) of rank 1 and an inner turn (L8, L9, L10) of rank N, the inner turn being connected to an internal connection pad (IP, IP10) and the outer turn being connected to an external connection pad (EP, EP1),
- attaching a microcircuit (MC) to the first face of the wafer, in a central area (CA) of the antenna coil delimited by a turn of the antenna coil, and
- connecting first connection terminals of the microcircuit (MC) to connection pads of the antenna coil, via wires (W1, W2),
wherein the first layer is etched in such a way that the external (EP, EP1) and internal (IP, IP10) connection pads of the antenna coil are formed in the central area (CA) of the antenna coil, the antenna coil comprising a bypass area (BA3-BA6, BA10-BA16) in which each turn bypasses the external connection pad via the central area,
**characterized in that** the first layer is etched in such a way that:
- the antenna coil comprises a first group of turns (L1-L5, L1-L6) of ranks 1 to E, having substantially the same distance between turns (dl), the turn of rank E being the inner turn of the first group of turns, E being at least equal to 4,
- the central area (CA) is delimited by the contour of the inner turn (L5, L6) of the first group of turns, and
- the antenna coil comprises a second group of at least two turns (L7-L8, L6-L9, L7-L9, L7-L10) of ranks E+1 to N, which extends within the central area, each turn of the second group of turns comprising portions of turns (10-21) which are at variable distances (d10-d21) from the turn of preceding rank, said distances being comprised between said distance between turns (dl) and several times the distance between turns.

2. The method according to claim 1, comprising steps that consist in:
- depositing a second electrically conductive layer on a second face of the wafer,
- forming contact pads (C1-C6) in the second layer, and
- forming two rows (h1-h3, h4-h6) of two or three holes each in the wafer, until the contact pads of the second layer are reached, the rows of holes being substantially perpendicular to a longitudinal axis of the module,
method wherein the first layer is etched in such a way that all or some of the turns of the second group follow a path that passes between at least two holes of at least one row of holes.

3. The method according to one of claims 1 and 2, wherein the microcircuit (MC) is supported in whole or in part by at least the inner turn (L8, L9, L10) of the antenna coil and may also be supported by at least one turn portion of the first group of turns extending in the bypass area.

4. The method according to one of claims 1 to 3, wherein the conductive layer is etched so as to include a support structure (SS3-SS6, SS10-SS16) for supporting all or part of the microcircuit (MC), the support structure being electrically connected to the inner turn of the antenna coil.

5. The method according to claim 4, wherein at least one part of the support structure (SS3-SS6, SS10-SS16) forms a conductive path that is part of the inner turn of the antenna coil.

6. The method according to one of claims 1 to 5, wherein the conductive layer is etched so as to form, in the bypass area, at least one connection pad (EP2-EP6) for connecting to a turn of rank greater than 1 of the first group of turns.

7. The method according to claim 6, comprising a step that consists in connecting a first one of the first connection terminals of the microcircuit (MC) to the connection pad (EP2-EP6) of a turn of rank greater than 1 of the first group of turns.

8. The method according to one of claims 1 to 6, wherein the conductive layer is etched so as to form, in the central area, at least one connection pad (IP7-IP9) for connecting to a turn of rank lower than N of the second group of turns.

9. The method according to claim 8, comprising a step that consists in connecting a second one of the first connection terminals of the microcircuit to the connection pad (IP7-IP9) of a turn of rank lower than N of the second group of turns.

10. The method according to one of claims 1 to 9, comprising a step of depositing an electrically insulating protective layer (RL) on the microcircuit (MC) and the connection wires (CW, W1, W1).

11. The method according to one of claims 1 to 10, wherein the wafer belongs to a board (MB) wherein several contactless modules are collectively formed, the method comprising a step of cutting the board to individualize the modules, carried out after the connection of each microcircuit.

12. The method for manufacturing a contactless module according to one of claims 1 to 11, comprising a step of designing the antenna coil comprising:
- a step of determining at least one target value of the inductance (Lm) and one target value of the resistance (Rm) of the antenna coil as they should be seen from the first connection terminals of the microcircuit,
- a step of designing the first group of turns and the second group of turns in such a way that the inductance (Lm) and the resistance (Rm) of the antenna coil, as seen from the connection pads of the antenna coil, are close to the intended target values.

13. The method for manufacturing a contactless module according to one of claims 1 to 11, comprising a step of designing the antenna coil comprising:
- a step of determining a plurality of target values of the inductance (Lm) and of target values of the resistance (Rm) of the antenna coil as they should be seen from the first connection terminals of the microcircuit,
- a step of designing the first group of turns and the second group of turns, comprising the provision of several connection pads (EP, EP1-EP6, IP, IP7-IP10) for connecting to turns of different ranks of the first group of turns and/or of the second group of turns, so that the antenna coil has several pairs of connection pads, each pair of connection pads comprising one pad for connecting to a turn of the first group of turns and one pad for connecting to a turn of the second group of turns,
method wherein the design of the first and second groups of turns and the choice of the location of the connection terminals are carried out in such a way that the inductance (Lm) and resistance (Rm) of the antenna coil as seen from each pair of connection pads of the antenna coil are close to one of the values of the plurality of target values of the inductance (Lm) and of target values of the resistance (Rm) of the antenna coil.

14. A method for manufacturing a microcircuit card comprising the steps that consist in:
carrying out the method according to one of claims 1 to 13, in order to obtain a contactless module (M3-M6, M10, M10'),
forming an antenna coil (CL) in a card (CC), and
implanting the module in the card, the antenna coil of the card having at least one turn (CL2) close to the antenna coil (A3-A6, A10-A16) of the microcircuit in order to establish inductive coupling between the two antenna coils.

15. A contactless module (M3-M6, M10, M10'), comprising
- a wafer (B3-B6, B10-B16) covered on a first face with a first electrically conductive layer in which an antenna coil (A3-A6, A10-A16) is formed, the antenna coil including turns (L1-L8, L1-L9, L1-L10) of increasing rank from the outside toward the inside of the antenna coil, including an outer turn (L1) of rank 1 and an inner turn (L8, L9, L10) of rank N, the inner turn being connected to an internal connection pad (IP, IP10) and the outer turn being connected to an external connection pad (EP, EP1),
- a microcircuit (MC) attached to the first face of the wafer, in a central area (CA) of the antenna coil delimited by a turn of the antenna coil, and including first connection terminals connected to connection pads of the antenna coil via wires (W1, W2),
wherein the external (EP, EP1) and internal (IP, IP10) connection pads of the antenna coil are formed in the central area (CA) of the antenna coil, the antenna coil comprising a bypass area (BA3-BA6, BA10-BA16) wherein each turn bypasses the external connection pad via the central area,
**characterized in that**:
- the antenna coil comprises a first group of turns (L1-L6, L1-L7) of ranks 1 to E having substantially the same distance between turns (dl), the turn of rank E being the inner turn of the first group of turns, E being at least equal to 4,
- the central area (CA) is delimited by the contour of the inner turn (L5, L6) of the first group of turns,
- the antenna coil comprises a second group of at least two turns (L7-L8, L6-L9, L7-L9, L7-L10) of ranks E+1 to N, which extends within the central area, each turn of the second group of turns comprising portions of turns (10-21) which are at variable distances (d10-d21) from the turn of preceding rank, said distances being comprised between said distance between turns (dl) and several times the distance between turns.

16. The module according to claim 15, wherein the wafer comprises contact pads (C1-C6) on a second face of the wafer, two rows (h1-h3, h4-h6) of two or three holes each, made in the wafer, reaching the contact pads on the second face, the rows of holes being substantially perpendicular to a longitudinal axis of the module, and wherein all or part of the turns of the second group of turns follow a path that passes between at least two holes of at least one row of holes.

17. The module according to one of claims 15 and 16, wherein the microcircuit (MC) is supported in whole or in part by at least the inner turn (L8, L9, L10) of the antenna coil and may also be supported by at least one turn portion of the first group of turns extending in the bypass area.

18. The module according to one of claims 15 to 17, wherein the conductive layer includes a support structure (SS3-SS6, SS10-SS16) for supporting all or part of the microcircuit, the support structure being electrically connected to the inner turn of the antenna coil.

19. The module according to claim 18, wherein at least one part of the support structure (SS3-SS6, SS10-SS16) forms a conductive path that is part of the inner turn of the antenna coil.

20. The module according to one of claims 15 to 19, wherein the antenna coil comprises, in the bypass area, at least one connection pad (EP2-EP6) for connecting to a turn of rank greater than 1 of the first group of turns.

21. The module according to claim 20, wherein a first one of the first connection terminals of the microcircuit (MC) is connected to the connection pad (EP2-EP6) of a turn of rank greater than 1 of the first group of turns.

22. The module according to one of claims 15 to 21, wherein the antenna coil comprises, in the central area, at least one connection pad (IP7-IP8, IP9a, IP9b) for connecting to a turn of rank lower than N of the second group of turns, to which a second one of the first connection terminals of the microcircuit is connected or can be connected.

23. A microcircuit card (CC) comprising an antenna coil (CL) and a contactless module (M3-M6, M10, M10') according to one of claims 15 to 22, the antenna coil of the card having at least one turn (CL2) close to the antenna coil (A3-A6, A10-A16) of the module, in order to establish inductive coupling between the two antenna coils.
